(19) Europäisches Patentamt
European Patent Office
Office européen des brevets

(11) **EP 4 741 846 A1**

(12) **EUROPEAN PATENT APPLICATION**

(43) Date of publication:
**13.05.2026 Bulletin 2026/20**

(21) Application number: **24211265.4**

(22) Date of filing: **06.11.2024**

(51) International Patent Classification (IPC):
**G01R 31/367** (2019.01)    **G01R 31/374** (2019.01)
**G01R 31/392** (2019.01)

(52) Cooperative Patent Classification (CPC):
**G01R 31/367; G01R 31/374; G01R 31/392**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **VITO NV**
**2400 Mol (BE)**

(72) Inventors:
• **COUTO MENDONCA, Luis Daniel**
  **2400 Mol (BE)**
• **MULDER, Grietus**
  **2400 Mol (BE)**
• **PONNETTE, Rafaël Frank L.**
  **2400 Mol (BE)**

(74) Representative: **V.O.**
**P.O. Box 87930**
**2508 DH Den Haag (NL)**

(54) **METHOD AND SYSTEM FOR PARAMETER IDENTIFICATION IN ELECTROCHEMICAL MODELS OF BATTERIES**

(57)    A method and system for identifying parameters of an electrochemical model for characterization and/or operational management of batteries. Battery performance data is collected under various conditions, applying an electrochemical model to simulate battery chemistry and degradation. The model parameters are segmented into subsets related to specific conditions and aging effects. An optimization framework then estimates each subset of parameters by resolving individual optimization problems based on the performance data. These estimated parameters are used to refine the electrochemical model, which is subsequently employed for further characterization and management of batteries.

FIG 3

**EP 4 741 846 A1**

**Description**

FIELD OF THE INVENTION

The invention relates to a method and system for identifying parameters of an electrochemical model for characterization and/or operational management of batteries. The invention also relates to a method for operating a lithium-ion battery within a defined safe operating area, determined based on the electrochemical model parameters identified.

The invention also encompasses the field of systems and methods for collecting and processing battery performance data under a variety of operating conditions to facilitate the accurate modeling and management of batteries Furthermore, the invention relates to a system for parameter identification in an electrochemical model of batteries, the system comprising: a battery testing apparatus configured to simulate operational conditions and collect measurement performance data under various battery operating conditions so as to collect data for identifying parameters of an electrochemical model of the battery being tested.

Furthermore, the invention relates to methods and systems for analyzing and managing the performance and operational characteristics of batteries. Further, the invention is also concerned with various aspects of battery management, including parameter identification in battery models, battery characterization, operational management, and age-related degradation modeling.

Additionally, the invention relates to a computer program product.

BACKGROUND TO THE INVENTION

Battery technology is widely used for various applications. For instance, lithium-ion batteries are increasingly utilized across a wide range of modern applications, from portable consumer electronics and electric vehicles, to large-scale energy storage systems. These batteries are favored for their high energy density, long life cycle, and relative stability. Yet, despite these advantages, the effective management and maintenance of batteries, such as for instance lithium-ion batteries, remain challenging due to the complexity and variability in their aging processes as well as slight variations in parameters amongst manufactured cells.

A primary issue within the current state of the art is the inefficiency in predicting the longevity and performance deterioration of lithium-ion batteries under different use conditions over time. Degradation of these batteries not only diminishes their capacity but also affects other performance metrics, impacting safety and reliability considerations for end-users.

The degradation in lithium-ion batteries stems from a multitude of interconnected physical and chemical processes, making it difficult to predict and manage. Sources of degradation include but are not limited to, the growth of the solid-electrolyte interphase (SEI) layer, electrode delamination, corrosion of current collectors, and other phenomena associated with the loss of lithium inventory and active material. Different batteries may experience these degradation mechanisms to varying extents depending on their specific chemical compositions, physical cell architecture and operational usage patterns.

Several models exist to predict the life-time and deterioration of batteries. Existing prediction models can be broadly classified into empirical or semi-empirical models, physics-based models, equivalent circuit models, and data-driven models. While physics-based models offer detailed insights into the internal processes of a battery, they tend to be computationally demanding. Empirical and semi-empirical models, although faster and simpler, often lack the depth of understanding needed to accurately predict battery life under varying conditions. Data-driven models require substantial data and are prone to inaccuracies when used outside the specific conditions under which they were developed.

Current technologies often struggle with flexibility and require extensive recalibration as operational or environmental conditions change. For instance, many models do not seamlessly account for the complexity of interdependent degradation mechanisms.

This inability to accurately account for, predict, and manage battery degradation under multifarious conditions leads to significant inefficiencies. Batteries may be prematurely discarded or replaced, incurring unnecessary costs and environmental waste, or alternatively, they may be used beyond their safe operational limits, posing safety risks.

Hence, there is a clear and present need for an improved and more practical approach in the modeling and prediction of battery degradation mechanisms that comprehensively address the nuanced interplay of aging factors under varying operational conditions. Such an approach would ideally reduce predictive errors, extend battery life, reduce costs, and increase the safety and efficiency of battery-dependent technologies. Unfortunately, the inclusion of equations in the battery model for various degradation mechanisms under multifarious conditions poses a big challenge with respect to the validation of the model as the number of parameters increases and the data required to estimate these at the same time. Additionally or alternatively, the invention can make it easier to tackle this challenge.

## SUMMARY OF THE INVENTION

It is an object of the invention to provide for a method and a system that obviates at least one of the above-mentioned drawbacks.

Additionally or alternatively, it is an object of the invention to provide for an improved method and system for identifying parameters of an electrochemical model for characterization and/or operational management of batteries.

Additionally or alternatively, it is an object of the invention to improve the accuracy of predicting degradation and performance in batteries over their operational lifespan.

Additionally or alternatively, it is an object of the invention to enhance the robustness of battery management systems through improved model-based estimation techniques.

Additionally or alternatively, it is an object of the invention to provide a more effective means of assessing and managing battery health in order to for instance extend service life and/or reliability, and/or to enable the delivery of more services per unit of time.

Additionally or alternatively, it is an object of the invention to improve the efficiency of monitoring and optimizing operational conditions to mitigate battery degradation.

Thereto, the invention provides for a method for identifying parameters of an electrochemical model for characterization and/or operational management of batteries, the method comprising: obtaining measurement performance data of a battery under various battery operating conditions; employing an electrochemical model to simulate battery cell electrochemistry and degradation mechanisms; dividing model parameters of the electrochemical battery model into multiple subsets related to specific battery operating conditions and aging phenomena; utilizing an optimization-based framework that is configured to estimate each subset of model parameters by solving separate optimization problems using measurement performance data, wherein each optimization problem estimates a subset of parameters relevant under the specific operating conditions corresponding to the measurement performance data; adjusting the electrochemical battery model with the estimated parameters; and using the updated electrochemical battery model for characterization and/or operational management of batteries.

The computer-implemented method includes obtaining measurement performance data from a battery under varying operational conditions, then using an electrochemical model to simulate the battery cell's electrochemistry and associated degradation mechanisms. This process involves a division of the model's parameters into subsets that correlate with specific operational conditions and aging phenomena observed in the battery. An optimization-based framework is then engaged to estimate each parameter subset by solving distinct optimization problems tailored to the performance data available. This approach allows for precise adjustments to the electrochemical model based on these estimated parameters, leading to enhanced capabilities in battery characterization and operational management.

The modular approach to parameter optimization simplifies both the model parameters estimation and the complex problem of battery management system calibration, making it feasible to accurately model and manage individual cell behaviors within larger battery systems, incorporating these into predictive maintenance and operational strategies that optimize performance and safety.

The method has the capacity to tailor and accurately update the electrochemical model to accurately reflect real-world battery behavior under diverse conditions. By focusing on specific subsets of parameters that are relevant to particular operational scenarios and solving targeted optimization problems, the method efficiently refines the model parameters. This procedure can ensure high fidelity in modeling the battery's response to various conditions. The improved model can be used for instance to optimize the battery's operation and/or to extend its lifetime based on its modeled performance and degradation predictions.

The method facilitates more precise and adaptable battery usage strategies across varying environmental and operational conditions.

Optionally, model parameters of the electrochemical battery model are rearranged. In some examples, preset model parameters are grouped together in order to obtain a reduced set of model parameters. In this way, the number of model parameters to be identified can be reduced.

Optionally, the model parameters are divided into subsets corresponding to different stages and conditions of battery use and aging, and each subset is estimated using measurement data relevant to that mechanism.

Subdividing model parameters according to distinct operational and aging scenarios can enhance the precision of the battery model.

The subdivision of model parameters in the battery model facilitates a more targeted and efficient estimation process, making it inherently easier to achieve.

The model can be tailored to specific conditions, thus improving its applicability in predicting battery performance under varying real-world situations. For example, by categorizing parameters into subsets related to various battery states, such as fresh, calendar-aged, and cycle-aged states, the method allows for a more accurate modeling of degradation phenomena that occur under different circumstances.

By categorizing model parameters into subsets associated with specific battery conditions and aging mechanisms, such as those identified through techniques like Electrochemical Impedance Spectroscopy (EIS), Galvanostatic Intermittent Titration Technique (GITT), Incremental Capacity Analysis (ICA), etc., the method enhances the precision of the electrochemical battery model.

This tailored modeling framework enables the creation of a battery model that can predict the battery's behavior more accurately through its lifecycle. For instance, calendar aging parameters specifically address aging effects due to time and environmental conditions without cycling, while cycle aging parameters focus on wear and tear due to repeated charging and discharging. This segregation of parameters and targeted optimization allows for the exploration of specific hypotheses about degradation mechanisms under controlled conditions. It results in a model that isn't just a general approximation but a detailed representation that responds to specific aging processes.

By employing targeted measurement data for each subset of parameters, the estimation process becomes less prone to overfitting and more reflective of the battery's actual behavior under specific conditions. This leads to more accurate predictive models, important for applications such as electric vehicles and grid storage, where the prediction of battery lifespan and performance impacts both economic and operational planning.

The method's ability to segregate and focus on various aspects of battery usage and deterioration not only enhances the model's accuracy but also enriches the understanding of how different factors contribute to battery aging. This can inform both the design of new battery technologies and the operational protocols to maximize battery lifespan.

Optionally, a multi-step identification procedure is performed including: identifying a set of initial parameters of a new battery cell, the initial parameters including equilibrium parameters that characterize the battery's behavior under pseudo-equilibrium conditions (e.g. stable) and dynamic parameters that characterize the battery's behavior under dynamic operational conditions; utilizing the identified initial parameters as a basis for modeling battery aging, wherein the modeling includes: incorporating calendar aging parameters into the model, which account for degradation effects due to the passage of time; and incorporating cycle aging parameters into the model, which account for degradation effects due to long-term operational use; wherein the initial parameters serve as foundational configurations for the battery model, and adjustments are made to these configurations based on the calendar aging parameters and cycle aging parameters to model and/or predict the battery's degradation over time.

The multi-step identification method may first establish foundational parameters for a new/fresh battery. The foundational parameters may include dynamic parameters which characterize the battery's responsive behavior under different operational loads. These parameters help in understanding real-time operational characteristics of the battery.

Upon this foundation, the model may integrate additional aspects, including calendar aging parameters which address degradation due to time-related effects such as SEI layer growth (and/or other mechanisms) and are assessed using data from aging tests where the battery remains at specific states of charge; and cycle aging parameters which account for usage-related degradation mechanisms like surface cracking to name just one mechanism and are evaluated from cycling test data, tracking how charge-discharge cycles affect battery material integrity. It will be appreciated that other degradation mechanisms may be applicable.

The division and separate optimization of these parameters through targeted tests allow for a comprehensive modeling strategy that captures both instantaneous and progressive changes in battery conditions. This facilitates accurate modeling of how batteries degrade depending on both environmental impacts and usage patterns.

By categorizing and independently deriving parameters associated with distinct aging processes, the model can more accurately forecast battery life and performance. This accuracy can be important for developing effective battery management systems that prevent premature degradation and enhance battery utilization efficiency.

Understanding exact battery degradation factors enables the design of customized usage strategies. For instance, knowing how a battery degrades under specific loads or conditions allows operators to tweak operational conditions to slow degradation, thereby extending the battery's operational life and efficiency.

With detailed insights into how batteries degrade, maintenance can be scheduled more effectively. Predictive maintenance becomes feasible, allowing maintenance activities to be performed when needed instead of per a fixed schedule. This not only saves costs but also minimizes downtime and extends battery life.

The underlying principles and parameter identification processes are applicable to various battery types, making the method versatile and adaptable across various applications, from electric vehicles to grid storage systems.

By optimizing the battery usage conditions and accurately predicting the battery's lifespan and potential failures, the operational costs are minimized, and the return on investment is maximized. This predictive capability aids in economic planning and can lead the market towards more reliable and economically viable battery solutions.

Optionally, the parameter identification comprises: determining, using low-current and/or open-circuit potential measurement performance data, a low-current or open-circuit potential, OCP, function of the battery electrodes to establish baseline equilibrium parameters; estimating, using dynamic measurement performance data including charging and discharging at various rates, dynamic parameters that indicate the battery's response under dynamic operational conditions; estimating, using data from aging tests where batteries are held at specific states of charge without cycling, calendar aging parameters that indicate calendar aging; estimating, using data from measurements in which the battery is subjected to repeated charge-discharge cycles under controlled conditions, cycle aging parameters that indicate cycle aging; applying an optimization algorithm to refine all identified parameters ensuring the model predictions align closely with the observed data; and combining all identified parameters into a comprehensive battery model for predicting the battery's behavior over its expected lifespan under various usage scenarios.

First, a foundation may be established using measurement data to determine baseline equilibrium parameters. These parameters are important as they define the battery's response in pseudo-equilibrium, non-dynamic conditions, setting the stage for further parameter estimations that account for more complex, real-world operational scenarios.

These foundational parameters may include equilibrium parameters which are derived under quasi-static or pseudo-equilibrium conditions using e.g. low-current or OCP data. Such parameters predominantly include OCP functions and equilibrium parameters. The foundational parameters may also include dynamic parameters which characterize the battery's responsive behavior under different operational loads and are typically derived from data associated with various charge and discharge rates. These parameters help in understanding real-time operational characteristics of the battery.

As the model parameterization progresses, dynamic parameters are introduced by leveraging data from diverse charge and discharge cycles. This step can be important for capturing the battery's responses under varied operational stress, where the battery undergoes different rates of charging and discharging. The dynamic parameters, thus, enrich the model's capacity to simulate real-time battery behavior, making the predictions more robust and reliable. In some examples, the cycle aging parameters are estimated using data from measurements in which the battery is subjected to repeated charge-discharge cycles under controlled conditions at various rates, at different states (cf. SoC windows) and/or at different environmental conditions.

Furthermore, aging parameters are integrated, which are segmented into calendar and cycle aging categories. Calendar aging parameters are derived from tests where the battery undergoes aging purely due to time, without the influence of operational cycles. In contrast, cycle aging parameters are calculated from data where the battery is subjected to repeated cycling processes. These parameters are important for understanding and predicting how the battery's capacity and performance degrade over time and use, thereby enabling more accurate lifecycle management and maintenance scheduling.

The comprehensive and segregated approach to parameter estimation, effectively ensures that each aspect of the battery's behavior is modeled and taken into account. This segregation not only simplifies the complex task of parameter identification/estimation but also significantly enhances the accuracy of the model. By minimizing the discrepancies between the modeled behavior and the observed data through rigorous optimization procedures, the claim ensures the model remains highly reflective of the actual battery performance.

Ultimately, the resultant electrochemical model, enriched with finely tuned parameters across various operational and aging conditions, serves as a robust tool for predicting battery behavior. This predictive capability is important for planning in battery deployment, operational management, and maintenance in various applications, ranging from electric vehicles to stationary energy storage systems.

Optionally, OCP functions per electrode are determined by measuring voltage response of the battery electrodes under low-current or zero-current conditions and fitting the data to obtain functional representations of the OCPs, wherein the OCP functions are determined by fitting measured OCP data to a set of basis functions selected from exponentials and hyperbolic functions.

The determination of OCP functions per electrode from voltage response measurements at low currents can be important for establishing a solid foundation within the battery modeling process. The cell level OCP represents the voltage between the electrodes of a battery when no external current is being applied. The cell level OCP is the combination of the OCP of the electrodes making up the cell. Accurately characterizing this function can be important because it directly impacts how other aspects of the battery's behavior are modeled, particularly under varying operational conditions.

OCP functions serve as the baseline for understanding the intrinsic electrochemical potential of the battery's electrodes. This is important when no load is present, providing a neutral reference point against which changes due to operational loads can be measured.

Accurate OCP readings ensure that subsequent modeling of dynamic behaviors such as charge and discharge cycles reflects true battery behavior under operational stresses. Any errors in determining the OCP can lead to significant deviations in predicted versus actual battery performance, affecting the reliability of the model's output.

OCP values affect other parameters in the battery model. For example, electrochemical reactions' kinetics and diffusion processes are influenced by the potential differences established by the OCP. Incorrect OCP values can skew the estimation of reaction rates and diffusion coefficients, leading to inaccurate aging predictions.

In order to achieve a representation of the OCP functions, employing a set of basis functions like exponentials or hyperbolic functions is an effective approach. This method allows for a more flexible and refined fitting of the voltage response data, accommodating the non-linear characteristics of OCP across different state-of-charge levels and optionally temperatures.

Optionally, estimating equilibrium parameters involves solving a nonlinear least squares optimization problem that minimize the difference between measured and modeled voltage under low-current conditions.

The estimation of these equilibrium parameters can be carried out by first collecting experimental voltage data from the battery when subjected to low-current or steady-state conditions. This can involve either very low or no current conditions to ensure the system remains in a state as close to equilibrium as possible. The nonlinear least squares optimization is then applied to these data points. This involves setting up a cost function that measures the discrepancy between observed voltages (from real battery data) and those predicted by the model under similar conditions.

The optimization task focuses on minimizing the sum of the squares of the voltage discrepancies. This method is well-suited for dealing with potential issues of non-linearity in parameter relationships within the battery model. By minimizing this cost function, the most probable parameter values that reflect the true behavior of the battery under equilibrium conditions are identified.

Properly capturing the baseline behavior reduces errors when the model is extended to include dynamic operations like charging and discharging or degradation mechanisms like calendar and cycle aging.

Once equilibrium parameters are established, they serve as the basis for adding layers of complexity, such as dynamic parameters which describe the battery's response to active charging and discharging, and aging parameters, which predict degradation over time. This stepwise building of the model ensures a coherent integration of various aspects, from static to dynamic and from operational to degradation behaviors.

Optionally, estimating dynamic parameters involves solving an optimization problem that minimize the difference between measured and modeled voltage during charge/discharge cycles at different current rates, to determine solid-phase diffusion time coefficients, reaction rate constants for positive and negative electrodes, and/or a lumped resistance parameter.

Dynamic parameters, which include variables such as solid-phase diffusion coefficients, reaction rate constants, and resistances, are important for accurately simulating how lithium-ion batteries respond to various charging and discharging conditions.

The optimization process for estimating dynamic parameters may involve several steps. Data collection may involves gathering extensive voltage, current, and temperature data from the battery under various operating conditions. Battery management systems may provide the necessary data, capturing detailed performance metrics during different charge/discharge cycles.

A modeling framework such as a single-particle model (SPM) or its extensions, may form the basis of simulations. It will be appreciated that other models than the SPM may be used.

Techniques such as least squares, gradient descent, or genetic algorithms can be applied to minimize the discrepancies between the model predictions and actual observed data. The goal is to adjust the dynamic parameters so that the model output aligns closely with real-world behavior.

Post-optimization, the updated model may be validated under controlled experiments to ensure that the predictive performance matches expectations. Any discrepancies lead to further refinements of the dynamic parameters.

Optionally, estimating calendar aging parameters involves modeling capacity fade and/or power fade over time under storage conditions and solving optimization problems to fit the model to the measured capacity loss data, in order to determine at least parameters associated with solid electrolyte interphase (SEI) layer growth.

The incorporation of calendar aging parameters by modeling capacity fade over time under non-cycling conditions directly impacts the accuracy and relevance of the electrochemical model for lifespan prediction and maintenance scheduling. Data collection may be done under specific states of charge (SOC) and conditions that simulate real-world battery storage scenarios. In some examples, also temperatures may be taken into account. Employing a physics-based model, such as the Single Particle Model (SPM), extended to account for degradation mechanisms provides a deep understanding of the internal changes happening within the battery chemistry over time. This approach allows for the SEI layer growth and other physical changes to be modeled with a high degree of precision.

Parameters like those associated with the SEI layer growth, which may vary with the SOC and temperatures, can be determined through mathematical optimization techniques, ensuring that the model's predictions reliably represent actual battery behavior under passive aging conditions.

The model can gain the capacity to accurately predict the decline in battery performance due to non-operational aging. This predictive power is important for planning maintenance and estimating the battery's end of life based on passive degradation, which can be important for applications where batteries experience prolonged intervals of inactivity.

It will be appreciated that instead of capacity fade and/or power fade, also other factors may play an important role and employed for estimating calendar aging parameters.

Optionally, the calendar aging parameters further include parameters that are function of the state of charge (SOC) so as to account for SOC-dependent degradation.

By accounting for variations in battery degradation across different states of charge, the model can more precisely predict the battery's lifespan and performance degradation under realistic use conditions.

This approach recognizes and quantifies how different states of charge affect the rate and nature of degradation processes within the battery, such as the formation of the solid-electrolyte interphase (SEI) layer, which is known to be influenced by the battery's state of charge.

The model dynamically adapts to changes in operational conditions that affect degradation, such as fluctuations in state of charge during regular use, enabling accurate predictions in real-time or near real-time scenarios.

With precise aging predictions, battery management systems can proactively address potential issues, schedule maintenance, and prevent sudden failures, enhancing operational reliability and safety.

Optionally, estimating cycle aging parameters involves modeling capacity fade due to cycling-induced degradation mechanisms and solving optimization problems to fit the model to the measured capacity loss data during cycling, to determine parameters associated with at least surface cracking propagation in the electrode materials of the battery.

The process of identifying and modeling the cycle aging parameters notably encompasses the degradation mechanisms induced by continuous operational cycling, such as surface cracking propagation. This enables the model to simulate the gradual reduction in battery performance due to repeated charge and discharge cycles reliably. By empirically fitting these parameters to the recorded capacity loss data gathered under various controlled cycling conditions, the predictive model is significantly enhanced.

Surface cracking in battery electrodes occurs due to the mechanical stresses exerted during the lithium ions' intercalation and deintercalation processes. This mechanical degradation often accelerates under high rates or severe cycling conditions.

The cycle aging parameters are fine-tuned to model this phenomenon, providing a framework to analyze how microstructural changes within the electrode material impact overall battery health and capacity.

The identification of cycle aging parameters through controlled experiment data allows for the calibration of the model to reflect actual degradation behaviors observed in practical settings.

Accurate modeling of cycle aging supports the development of batteries that last longer and require fewer resources over time, promoting sustainability in battery production and usage. It also aids in the responsible recycling and refurbishing of batteries by providing data on when batteries are in some examples to fall below operational thresholds.

It will be appreciated that while surface cracking propagation is a factor considered for estimating cycle aging parameters, other degradation mechanisms may also play a role. Recognizing and incorporating diverse mechanisms into the cycle aging model can enhance its robustness and accuracy.

Optionally, the battery model is a physics-based electrochemical model, comprising: a single-particle model (SPM) for simulating the electrochemical interactions within the battery under various operational states; an extension of the single-particle model to include degradation mechanisms represented by solid-electrolyte interphase (SEI) layer growth for calendar aging and surface cracking propagation for cycle aging, whereby: the SEI layer growth is modeled to reflect degradation due to chemical and physical changes occurring over time as a result of environmental conditions and state of charge; the surface cracking propagation is modeled to account for mechanical degradation effects resulting from the cyclic stress and strain experienced during operational use of the battery; and wherein the integrated SEI layer growth and surface cracking propagation mechanisms are adjusted based on the initial equilibrium and dynamic parameters.

The integration of the single-particle model (SPM) with specific degradation mechanisms like solid-electrolyte interphase (SEI) layer growth and surface cracking propagation offers an approach to understanding and predicting the dynamic behavior and longevity of lithium-ion batteries. This method effectively captures both the instant electrochemical reactions and the gradual degradation processes that impact battery performance over extended periods and diverse operational conditions. By emphasizing a targeted inclusion of degradation mechanisms, the model achieves an advantageous balance, it remains computationally manageable while encapsulating the important elements that influence battery health and efficiency.

The SPM provides a simplified yet accurate representation of the electrochemical processes within a battery cell. By extending this model to include key degradation mechanisms, SEI layer growth and surface cracking propagation, it addresses the aging phenomena without overwhelming the model with excessive complexity. This balance can be important for practical applications where both accuracy and computational efficiency are required.

With the degradation mechanisms incorporated, the model no longer only simulates ideal or fresh battery conditions but also realistically predicts how batteries will age under specific circumstances. This includes estimating the rate of capacity fade and the impact of various charging and discharging patterns.

The division of the model parameters into subsets associated with different operational and aging conditions simplifies the parameter estimation process. By applying optimization techniques that specifically target subsets relevant under particular conditions, the estimation process becomes more efficient and manageable. This methodological structuring not only simplifies data handling but also enhances the accuracy of the model by ensuring that each parameter subset is optimized based on the most relevant empirical data.

Through accurate simulations of battery degradation, the model supports enhanced decision-making in terms of maintenance scheduling and operational adjustments. For instance, by understanding the specific conditions that accelerate aging, users can tweak operational parameters to extend battery life, thus optimizing both performance and cost-efficiency.

By identifying a 'safe operating area' based on the model's insights into electrochemical behavior and degradation, the approach enhances the safety and reliability of battery usage. This proactive management helps in preventing conditions that can lead to battery failure or hazardous situations, thereby assuring both user safety and operational integrity.

Optionally, discretization of the model equations is performed using spectral methods.

Discretization using spectral methods plays an important role in the implementation of the electrochemical model according to the disclosure, particularly when simulating intricate battery dynamics and aging phenomena. Spectral methods, a class of numerical techniques for solving differential equations, offer several advantages that make them especially suitable for handling the complexities involved in battery modeling.

Spectral methods are known for their high accuracy, particularly in approximating smooth solutions over complex domains. By employing these methods, the model can capture the dynamics of electrochemical processes within batteries with greater precision, which can be important for both the initial characterization and the long-term management of battery degradation.

These methods can achieve a given level of accuracy with far fewer points or nodes compared to traditional methods like finite difference or finite element methods. This efficiency is derived from the fact that spectral methods use global polynomials or trigonometric functions that approximate the solution over the entire computational domain, rather than focusing on increments between discrete points. This attribute significantly reduces computational load and speeds up the simulation process, which is particularly beneficial when modeling the continuous operation and aging of batteries over extended periods.

In the simulation of processes that evolve over time, such as the degradation mechanisms in batteries, spectral methods often exhibit improved stability and convergence properties compared to other numerical methods. This stability can be important for ensuring that the simulation remains reliable and accurate over long simulation times or under various operational stress conditions.

In the context of the electrochemical model, discretization using spectral methods may involve converting the continuous differential equations of the battery's behavior and degradation mechanisms into a form suitable for spectral approximation. Appropriate basis functions (e.g., Chebyshev polynomials or Fourier series) may be selected based on the specific requirements of the battery model, such as the need for handling irregular boundaries or capturing sharp gradients in ion concentrations. The collocation points may be determined where the differential equations are to be satisfied. The differential equations at the collocation points create a system of algebraic equations. Solving these equations provides the coefficients of the basis functions, which define the solution over the entire domain.

It will be appreciated that while spectral methods are employed in some examples for the discretization of model equations, alternative numerical techniques could be considered based on the specific requirements of the battery model.

According to an aspect, the invention provides for a system for identifying parameters of an electrochemical model that includes aging mechanisms for characterization and/or operational management of batteries, the system comprising: one or more processors; memory storing instructions that, when executed by the one or more processors, perform the method according to the disclosure.

Parameters of an electrochemical model can be identified that accurately predicts the behavior and degradation of batteries, such as lithium-ion, throughout their lifetime. An improved optimization-based approach is employed to identify model parameters, allowing for a more accurate and systematic prediction of battery lifetime under different operating conditions. The method encompasses both the identification of fresh cell parameters and the evolution of these parameters as the battery ages due to calendar and cycle effects, thereby providing a full lifecycle model.

Batteries, especially lithium-ion variants, have complex chemistries with reactions that can be sensitive to a multitude of factors. The invention allows to affectively capturing this complexity in a model, making accurate modeling feasible. The identified model demonstrates enhanced accuracy, with voltage and capacity errors notably smaller than those reported in prior studies, thus enhancing the prediction of battery performance and degradation.

In some examples, a single-particle model of the battery is employed that incorporates degradation mechanisms such as solid-electrolyte interphase (SEI) layer growth and surface cracking. This model can be used to simulate both fresh and aged battery cells under various conditions of calendar and cycle aging.

According to an aspect, the invention provides for a method for identifying parameters of an electrochemical battery model that includes degradation mechanisms, the method comprising: obtaining multiple data sets from battery cells under various operating conditions, the data sets including pseudo-equilibrium data, dynamic charge/discharge cycling data, calendar aging data, and cycle aging data, with variations in current rates, state-of-charge (SOC) levels, SOC windows, and temperatures; defining an electrochemical battery model that incorporates degradation mechanisms corresponding to solid electrolyte interphase (SEI) layer growth and surface cracking propagation, wherein the model is structured with a minimum number of grouped parameters to be identified; determining open-circuit potential (OCP) functions for the positive and negative electrodes, either by direct electrochemical characterization measurements or by utilizing known OCP functions from literature based on the electrode chemistries; estimating equilibrium parameters by solving an optimization problem that minimizes the error between modeled and measured equilibrium voltages under low current conditions, the optimization being constrained by material balance and equilibrium conditions within the model; estimating dynamic parameters by solving an optimization problem that minimizes the error between modeled and measured voltages during dynamic charge/discharge cycling, the optimization being constrained by the dynamic equations of the electrochemical model for fresh cells; estimating calendar aging parameters by solving an optimization problem that minimizes the error between modeled and measured capacities over time during calendar aging tests, incorporating the SEI layer growth model into the optimization process; estimating cycle aging parameters by solving an optimization problem that minimizes the error between modeled and measured capacities over time during cycle aging tests, incorporating the surface cracking propagation model into the optimization process; applying the identified parameters to the electrochemical model to simulate battery performance and degradation over time; wherein the parameter identification relies on optimization problems specific to each identification step.

According to an aspect, the invention provides for a method for operating a lithium-ion battery within a defined safe operating area, determined based on the electrochemical model parameters identified according to the above-mentioned identification method.

Initially, the battery may undergo testing under various conditions to gather performance data, which includes responses to different charge and discharge currents, temperature conditions, and aging processes. This data serves as the basis for modeling the battery using an electrochemical model that accounts for both the electrochemical reactions and the specific degradation mechanisms which the battery may experience over its operational life.

Parameters such as reaction rates, diffusion coefficients, and parameters specific to degradation mechanisms like solid-electrolyte interphase (SEI) layer growth and surface cracking propagation, are calculated using optimization algorithms. This step can be important as these parameters influence the battery's operational dynamics and degradation trajectory. The parameters are updated iteratively until the model's predictions align closely with the experimental data, confirming the model's accuracy.

In some examples, with a well-calibrated model, the next step may be defining the battery's safe operating area (SOA). The identified parameters guide the determination of operational boundaries such as optimal charge and discharge rates, temperature limits, and state-of-charge (SOC) ranges that the battery can safely handle. These boundaries are informed by the battery's physical and chemical limitations as identified during the modeling phase.

For instance, parameters related to the SEI layer growth may indicate how fast the battery degrades under certain SOCs and temperatures, informing the upper limits of these conditions in the SOA. Parameters related to surface cracking may guide the mechanical stress limits the battery can endure during operations, influenced by factors like charge rate and depth of discharge.

Using the defined SOA, operational strategies may be developed to optimize battery usage without compromising safety. For instance, based on the model's insights, charging methods can be dynamically adjusted to extend the battery's life. For example, slower charging rates may be recommended when the battery is at higher temperatures to reduce stress and prolong life. Additionally or alternatively, the battery management system may use the identified parameters to keep the SOC within a range that minimizes degradation but maximizes available capacity, adjusting the range based on the battery's age and health. Additionally or alternatively, operational guidelines may be employed based on the predictions, the guidelines including temperature controls such as cooling strategies and/or operational pauses when certain thermal thresholds are detected.

In some examples, the operational management system not only uses the SOA for daily operations but also for predictive maintenance. By continuously comparing real-time operational data with the model's predictions, the system can identify early signs of unexpected degradation or operational anomalies. This proactive approach allows for timely maintenance actions before the battery's performance is significantly compromised.

In some examples, as batteries are used and operational data continues to be collected, this data can be fed back into the model to refine and update the parameters. This ongoing process allows for the SOA to be dynamically adjusted in response to real-world performance and aging, ensuring that the operational strategies remain optimal throughout the battery's lifespan.

According to an aspect, the invention provides for a system for parameter identification in an electrochemical model of batteries, the system comprising: a battery testing apparatus configured to simulate operational conditions and collect measurement performance data under various battery operating conditions; at least one processing unit that is configured to perform the identification method according to the disclosure, using the measurement performance data collected by the battery testing apparatus, to identify parameters of an electrochemical model that includes aging mechanisms for characterization and/or operational management of batteries.

The system for parameter identification is configured to streamline the collection of important experimental data and subsequent calculation of parameters which are important for creating accurate and reliable electrochemical models of batteries. The battery testing apparatus can be important for simulating real-world operating conditions that the battery may face. It may be equipped to enforce various charge-discharge cycles, operational stress conditions, different states of charge, and temperature settings. This apparatus can mimic aging effects by accelerating them under controlled conditions, thereby providing a wealth of data for analysis.

It may be equipped with sensors and measurement devices to track voltage responses, current levels, temperature changes, and other relevant electrochemical reactions occurring within the battery.

A computer program product may be employed that can implement computer-implemented algorithms for the parameter estimation method according to the disclosure.

Collected data obtained by means of the data collection apparatus may be transmitted to the processing unit where preliminary data processing cleans and formats the data for analysis. Relevant subsets of data pertaining to different operating conditions or aging phenomena may be extracted according to the needs of distinct parameter identification tasks. The processing unit may apply optimization algorithms to estimate parameters of the electrochemical model that best fit the experimental data, using the parameter estimation method according to the disclosure. These parameters can then be used to update the model, refining its accuracy and reliability based on the latest data. In some examples, updated models can be tested further by simulating new operational scenarios in the battery testing apparatus, providing a feedback loop that continuously enhances model validity. This iterative process may ensure that the model remains valid over the battery's life span, adapting to new data and changing operational conditions.

With accurate and up-to-date models, the BMS can optimize battery usage based on current health and predicted lifespan, implementing strategies for charging and discharging that prolong battery life.

The system can predict when a battery will in some examples require maintenance, allowing preemptive intervention to avoid failures and extend the battery's operational life.

It will be appreciated that any of the aspects, features and options described in view of the methods apply equally to the systems and the described device, use and computer program product. It will also be clear that any one or more of the above aspects, features and options can be combined.

BRIEF DESCRIPTION OF THE DRAWING

The invention will further be elucidated on the basis of exemplary embodiments which are represented in a drawing. The exemplary embodiments are given by way of non-limitative illustration. It is noted that the figures are only schematic representations of embodiments of the invention that are given by way of non-limiting example.

In the drawing:

Fig. 1 shows a schematic diagram of an embodiment of a system;
Fig. 2 shows a schematic diagram of an exemplary battery cell structure and degradation mechanisms;
Fig. 3 shows a schematic diagram of an embodiment of a system;
Fig. 4 shows a schematic diagram of an embodiment of a system;
Fig. 5 shows a schematic diagram of an embodiment of a system;
Fig. 6 shows a schematic diagram of exemplary graphs;
Fig. 7 shows a schematic diagram of exemplary graphs;
Fig. 8 shows a schematic diagram of exemplary graphs;
Fig. 9 shows a schematic diagram of exemplary graphs;
Fig. 10 shows a schematic diagram of exemplary graphs;
Fig. 11 shows a schematic diagram of exemplary graphs;
Fig. 12 shows a schematic diagram of exemplary graphs;
Fig. 13 shows a schematic diagram of a method.

DETAILED DESCRIPTION

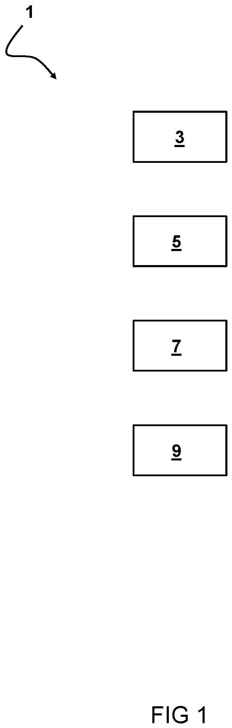

Fig. 1 shows a schematic diagram of an embodiment of a system 1 for determining parameters of an electrochemical model to characterize and/or manage the operation of batteries. The system 1 comprises a data acquisition module 3 configured to collect measurement performance data from a battery under various operating conditions. The system 1 also includes a modeling module 5 employing an electrochemical model to simulate the electrochemistry and degradation mechanisms of battery cells. Model parameters of the electrochemical battery model are categorized into multiple subsets, each subset corresponding to specific battery operating conditions and aging phenomena. The system 1 further includes an optimization framework 7 configured to estimate each subset of model parameters by resolving distinct optimization problems using the measurement performance data, wherein each optimization problem is tailored to estimate a subset of parameters that are pertinent under the specific operating conditions linked to the measurement performance data. The electrochemical battery model can be updated with the estimated parameters. The system 1 further includes an operational management module 9 using the adjusted electrochemical battery model for the characterization and/or operational management of batteries. Advantageously, the invention makes it easier to estimate the model parameters over a large representative dataset.

In some examples, the method is employed for identifying parameters in an electrochemical model of lithium-ion batteries, the method comprising:

(a) modeling the lithium-ion battery using a single particle model that incorporates degradation mechanisms including solid electrolyte interphase (SEI) layer growth and surface cracking propagation;
(b) (optionally) reducing the number of parameters to be identified by grouping them into a reduced/minimal set;
(c) acquiring multiple data sets from the battery under various operating conditions, the data sets comprising:

    (i) pseudo-equilibrium data representing low-current voltage measurements;
    (ii) dynamic charge/discharge cycling data at different current rates, state-of-charge levels, state-of-charge windows, and temperatures;
    (iii) calendar aging data representing capacity evolution over time under storage conditions; and
    (iv) cycle aging data representing capacity evolution over time under cycling conditions;

(d) determining open-circuit potential functions for the positive and negative electrodes by fitting known electrode potentials from literature or through experimental characterization;
(e) estimating equilibrium parameters, including electrode capacities and initial lithium content, by formulating and solving an optimization problem that minimizes voltage error between the model predictions and the pseudo-equilibrium data;
(f) estimating dynamic parameters, including diffusion coefficients, reaction rate constants, and contact resistance, by formulating and solving an optimization problem that minimizes voltage error between the model predictions and the dynamic cycling data;
(g) estimating calendar aging parameters associated with SEI layer growth by formulating and solving an optimization problem that minimizes capacity error between the model predictions and the calendar aging data;
(h) estimating cycle aging parameters associated with surface cracking propagation by formulating and solving an optimization problem that minimizes capacity error between the model predictions and the cycle aging data;
(i) iteratively refining the parameter estimates by applying the optimization problems in steps (e) through (h);

wherein the parameter identification relies on optimization problems specific to each identification step.

It will be appreciated that other exemplary data streams may be employed.

It will be appreciated that in step (b), other ways to reduce even further the parameter set may be employed, for example using sensitivities.

The method provides for an improved parameter identification that is applicable to different battery chemistries and electrochemical model structures.

Below, a systematic methodology for the parameter identification of an exemplary lifetime electrochemical model for LFP/graphite lithium-ion batteries is given. The model of a fresh cell corresponds to an SPM. A plausible degradation path for the calendar and cycle aging of the batteries is considered. Degradation mechanisms corresponding to SEI layer growth and surface cracking propagation are taken into account. The exemplary electrochemical model with aging features is described to have a minimum number of grouped parameters to be identified. In this example, four data sets were required for model identification, namely pseudo-equilibrium data, dynamic charge/discharge cycling data, calendar aging data and cycle aging data. Different current rates, SOC levels, SOC windows and temperatures were considered as operating conditions. The identification of model parameters were cast as optimization problems, where the voltage error was minimized to estimate equilibrium and dynamic parameters for fresh cells, whereas capacity error was minimized to estimate calendar and cycle aging parameters for aged cells. It will be appreciated that since the methodology relies on optimization problems for the different identification steps, it is generic and it can be applied to different battery chemistries as well as other electrochemical model structures.

In the following exemplary model parameters, model variables, equations, and model identification methods are given. Here follows a list of parameters/variables used therein.

- Model parameters:

    A - Cross-sectional area [$m^2$]
    A_max - Maximum amount of damage [-]
    c_el - Electrolyte phase concentration [$mol \cdot m^{-3}$]
    D - Diffusion coefficient [$m^2 \cdot s^{-1}$]
    E - Activation energy [$J \cdot mol^{-1}$]
    k - Reaction rate constant [$A \cdot m^2 \cdot s^{-1} \cdot mol^{-1.5}$]
    K - Equilibrium constant [$mol \cdot m^{-3}$]
    L - Electrode thickness [m]
    m_rate - Damage evolution rate [$A^{-1} \cdot s^{-1}$]
    M - Molecular weight [$g \cdot mol^{-1}$]

Q/Q_nom - Cell capacity/nominal capacity [Ah]
R - Particle radius [m]
R_c - Contact resistance [$\Omega \cdot m^2$]
U - Equilibrium potential [V]

- Model variables:

c - Solid phase lithium concentration [$mol \cdot m^{-3}$]
f - Fraction of broken bonds [-]
i - Current density [$A \cdot m^{-2}$]
I - Applied current [A]
SOC - State of charge [%]
t/t_k - Continuous/discrete time variable [s]
T/T_ref - Temperature/reference temperature [K]
V - Terminal voltage [V]

- Physical constants:

F - Faraday's constant [=96487 $C \cdot mol^{-1}$]
R_g - Universal gas constant [=8.31 $J \cdot mol^{-1} \cdot K^{-1}$]

- Symbols:

$\alpha$ - Apparent transfer coefficient [-]
$\delta$ - Film thickness [m]
$\varepsilon$ - Active material volume fraction [-]
$\phi$ - Potential [V]
$\rho$ - Density [$g \cdot m^{-3}$]

- Subscripts:

+/- - Positive/negative electrode
bb - Broken bonds variable
ef - Electrode-film interface
fs - Film-solution interface
film - Film variable
loss - Loss variable
sei - SEI layer variable
sol - Solution variable

- Superscripts:
_max - Maximum variable

Grouped parameters may be used. In an example, the following exemplary grouped parameters are used.

$$q_i = L_i A \varepsilon_i F c_i^{\max} \qquad \tau_{i,d} = R_i^2 / D_i \qquad c_1 = R_g T / (\alpha F)$$

$$\tau_{i,k} = k_i \sqrt{c_{\text{el}}} / R_i \qquad R_{cl} = R_- R_c / (3 L_- A \varepsilon_-) \qquad \bar{c}_i(r,t) = c_i(r,t) / c_i^{\max}$$

$$\bar{r} = r / R \qquad \beta = 3 \varepsilon_- L_- A / R_- \qquad k_{\text{sei}}^{T^{\text{ref}}} = F k_{\text{sei}}^{\text{ref}} K \exp\left(-\frac{E_{k,\text{sei}}^{T^{\text{ref}}}}{T^{\text{ref}}}\right)$$

$$D_{\mathrm{sei}}^{T^{\mathrm{ref}}} = \frac{F D_{\mathrm{sei}}^{\mathrm{ref}} K}{\delta_0} \exp\left(-\frac{E_{D,\mathrm{sei}}^{T^{\mathrm{ref}}}}{T^{\mathrm{ref}}}\right) \qquad \rho_M = F \delta_0 D_{\mathrm{sei}}^{T^{\mathrm{ref}}} \rho / M \qquad E_{k,\mathrm{sei}}^{T^{\mathrm{ref}}} = E_{k,\mathrm{sei}}/R_g$$

$$E_{D,\mathrm{sei}}^{T^{\mathrm{ref}}} = E_{D,\mathrm{sei}}/R_g$$

It will be appreciated that other grouped parameters may also be used.

Model identification

The SPM with degradation mechanisms is identified by following a multi-step identification procedure. This procedure relies on the recognition that the model parameters of different subset of equations can be identified from data depending on the considered experimental conditions. First, open-circuit potential (OCP) functions need to be determined from e.g. low-current voltage measurements of graphite and LFP versus lithium metal in half-cell configuration. Once the OCP functions are available, the following parameters can be estimated: equilibrium parameters, dynamic parameters, calendar aging parameters and cycle aging parameters, for which the following data sets are required from full-cell configuration measurements: low current, charge/discharge cycles at different Crates, long term storage and long-term cycling data, respectively.

OCP functions

In general, both positive and negative electrode OCPs can be identified from half-cell electrochemical characterization measurements. Typical characterizations include constant current charge/discharge at low current rates or galvanostatic intermittent titration technique (GITT). The latter consists of applying small charge or discharge current steps, followed by a given period of time when no current is applied and during which the potential of the studied electrode can be relaxed. The OCP is derived by gathering the potential value reached at the end of each relaxation period of the GITT characterization. A functional form for each measured OCP can be obtained by considering a set of possible basis functions (e.g. exponentials, hyperbolic functions, etc.) of the generic form [equation 20]:

$$V_{i,\mathrm{ocp}}^{\mathrm{mod}}(t_k) = f_{i,\mathrm{ocp}}(\theta_{i,\mathrm{ocp}})$$

wherein $V_{i,\mathrm{ocp}}^{\mathrm{mod}}(t_k)$ is the modelled OCP and $\theta_{i,\mathrm{ocp}}$ is the parameter vector to be estimated. The parameter identification problem can be cast as a curve fitting problem such as [equation 21]:

$$\underset{\theta_{i,\mathrm{ocp}}}{\mathrm{minimize}} \sum_{t_k=1}^{N_{i,\mathrm{ocp}}} w_{i,\mathrm{ocp}}(t_k)\left(V_{i,\mathrm{ocp}}(t_k) - V_{i,\mathrm{ocp}}^{\mathrm{mod}}(t_k)\right)^2$$

using the data set $D_{i,OCP} = \{V_{i,ocp}(t_k), t_k = 1, \ldots, N_{i,OCP}\}$ and $w_{i,ocp}(t_k)$ are possible weights.

This identification methodology requires the dismantling of the battery cell in order to recover electrodes samples to be characterized in half coin cells configuration for the determination of their OCP. As an alternative, here we leverage the fact that the electrode chemistries of the considered battery cell are known, namely graphite in the negative electrode and LFP in the positive electrode. Thus, OCP functions coming from literature for these electrode chemistries can be used directly. Notice that this alternative is more viable from the application viewpoint where the cells do not need to be opened, and specific experiments on electrodes in half coin cells configuration are not necessary. On the other hand, the downside is that we rely on literature OCPs that might slightly differ from the ones of the specific battery cells, which would in some cases introduce small model errors.

Equilibrium parameters

An equilibrium sub-model can be obtained by assuming that the applied current is small (i.e. $I(t) \approx 0$). Under this assumption, the electrode dynamics can be neglected and the integrator associated to the SOC evolution can be expressed as [equation 22]:

$$\frac{d\mathrm{SOC}_{i,\mathrm{eqm}}(t)}{dt} = \frac{1}{q_i} I(t)$$

$$\bar{c}_i(\bar{r},t) \approx \mathrm{SOC}_{i,\mathrm{eqm}}(t)$$

with initial conditions $SOC_{i,eqm}(0) = SOC_{i,eqm,0}$. Notice that a uniform concentration for each spherical particle follows from the assumption, and the voltage equation [equation 6]:

$$V(t) = U_+\big(\bar{c}_+(1,t)\big) - U_-\big(\bar{c}_-(1,t)\big) + c_1 \sinh^{-1}\left(\frac{-I(t)}{6q_+\tau_{+,k}\sqrt{\bar{c}_+(1,t)\big(1-\bar{c}_+(1,t)\big)}}\right)$$

$$- c_1 \sinh^{-1}\left(\frac{I(t)}{6q_-\tau_{-,k}\sqrt{\bar{c}_-(1,t)\big(1-\bar{c}_-(1,t)\big)}}\right) - R_{cl}I(t)$$

becomes [equation 23]:

$$V_{\mathrm{eqm}}^{\mathrm{mod}}(t) = U_+(\bar{c}_+(1,t)) - U_-(\bar{c}_-(1,t))$$

In this sub-model (equation 22), (equation 23), the SOC for each electrode $SOC_{i,eqm}(t)$ is driven by the applied current I(t) in (equation 22), and the uniform electrode concentration means that $\bar{c}_-(1,t) \approx SOC_{i,eqm}(t)$ in (equation 23), generating the modelled voltage $V_{\mathrm{eqm}}^{\mathrm{mod}}(t)$ in (equation 23). Moreover, material conservation can be used to link the lithium material between positive and negative electrodes under equilibrium conditions and by assuming that little to no degradation has occurred (i.e. fresh cell situation). This material balance is given by [equation 24]:

$$n_{Li} = q_+\bar{c}_{+,0} + q_-\bar{c}_{-,0}$$

where $n_{Li}$ stands for moles of lithium. Under the assumption that the equilibrium potentials are monotonic, the system of equations (equation 23) and (equation 24) can be solved to find the initial lithium concentrations for the parameter set $\theta_{eqm}$ given by [equation 25]

$$\theta_{\mathrm{eqm}} = [q_- \quad q_+ \quad n_{Li}]^{\mathrm{T}}$$

This set of equilibrium parameters is a subset of $\theta_{\mathrm{lump,spm}}$, a lumped parameter vector within a SPM of the battery (a grouped set of parameters that are estimated as a whole within the SPM), corresponding to electrode capacities $q_i$ plus the moles of lithium $n_{Li}$.

The estimate of $\theta_{eqm}$ can be determined by solving the following nonlinear least squares problem [equations 26, 27]:

$$\underset{\theta_{\mathrm{eqm}}}{\mathrm{minimize}} \sum_{t_k=1}^{N_{\mathrm{eqm}}} w_{\mathrm{eqm}}(t_k)\left(V_{\mathrm{eqm}}(t_k) - V_{\mathrm{eqm}}^{\mathrm{mod}}(t_k)\right)^2$$

subject to (equation 22) - (equation 24) using the data set $D_{eqm} = \{I_{eqm}(t_k), V_{eqm}(t_k), t_k = 1, \ldots, N_{eqm}\}$ where $I_{eqm}(t_k)$ and $V_{eqm}(t_k)$ are the low current and resulting voltage sequences, respectively.

Dynamic parameters

Once the OCPs and the equilibrium parameters have been determined, the dynamic parameter vector given by [equation 28]:

$$\theta_{\mathrm{dyn}} = [\tau_{-,d} \quad \tau_{+,d} \quad \tau_{-,k} \quad \tau_{+,k} \quad R_{cl}]^{\mathrm{T}}$$

can then be estimated using the data set for charge/discharge dynamic cycling denoted as $D_{dyn} = \{I_{dyn}(t_k), V_{dyn}(t_k), t_k = 1, \dots, N_{dyn}\}$. This parameter set is the complementary set to $\theta_{eqm}$ in (equation 25) as a subset of $\theta_{\mathrm{lump,spm}}$. The parameter estimate $\theta_{dyn}$ can be found by solving the following optimization problem [equations 29, 30]:

$$\underset{\theta_{\mathrm{dyn}}}{\mathrm{minimize}} \sum_{t_k=1}^{N_{\mathrm{dyn}}} w_{\mathrm{dyn}}(t_k) \left( V_{\mathrm{dyn}}(t_k) - V_{\mathrm{dyn}}^{\mathrm{mod}}(t_k) \right)^2$$

subject to (equation 5), (5b), (equation 6)

where the modelled voltage $V_{\mathrm{dyn}}^{\mathrm{mod}}(t_k)$ is given by (equation 6).

The estimated parameters (equation 25) and (equation 28) completely parameterize the SPM [equation 5]:

$$\frac{\partial \bar{c}_i(\bar{r},t)}{\partial t} = \tau_{i,d}^{-1} \left( \frac{2}{\bar{r}} \frac{\partial \bar{c}_i(\bar{r},t)}{\partial \bar{r}} + \frac{\partial^2 \bar{c}_i(\bar{r},t)}{\partial \bar{r}^2} \right)$$

$$\bar{c}_i(\bar{r},t)\big|_{\bar{r}=0} = 0$$

$$\bar{c}_i(\bar{r},0) = \bar{c}_{i,0}(\bar{r})$$

[equation 5b]:

$$\frac{\partial \bar{c}_i(\bar{r},t)}{\partial \bar{r}}\Bigg|_{\bar{r}=1} = -\frac{\tau_{i,d}}{3q_i} I(t)$$

and (equation 5b) associated to a fresh LFP/graphite cell, i.e. before any relevant cell degradation has occurred.

Calendar aging parameters

The fresh cell starts degrading just from the passage of time, as well as according to the conditions at which it is operated. Such degradation notably affects the capacity of the battery. In order to identify a possible degradation mechanism for the calendar aging of the considered cells, we first resort to the literature on LFP/graphite batteries. Most works point to SEI layer formation and growth, where the capacity evolution follows a square root of time dependency. Therefore, an SEI layer growth model is incorporated to the SPM of the fresh cell already identified. The to be identified parameter vector $\theta_{\mathrm{lump,sei}}$ , a grouped parameter vector associated with the calendar aging of battery cells due to the growth of the SEI layer, is given in [equation 14]:

$$\theta_{\mathrm{lump,sei}} = \left[ k_{\mathrm{sei}}^{T^{\mathrm{ref}}} \quad D_{\mathrm{sei}}^{T^{\mathrm{ref}}} \quad \rho_M \quad E_{k,\mathrm{sei}}^{T^{\mathrm{ref}}} \quad E_{D,\mathrm{sei}}^{T^{\mathrm{ref}}} \quad U_{\mathrm{sei}} \right]^{\mathrm{T}}$$

However, it was found that it was not possible to get a reasonable fit for different temperatures and SOCs by just adjusting the parameter vector as presented in (equation 14), but a $U_{\mathrm{sei}}$ as a function of SOC was required. Then, the parameter vector $\theta_{cal}$ to be estimated is equivalent to $\theta_{\mathrm{lump,sei}}$ in (equation 14) but with an SOC-dependent $U_{\mathrm{sei}}$, i.e. [equation 31]:

$$\theta_{\mathrm{cal}} = \begin{bmatrix} k_{\mathrm{sei}}^{T^{\mathrm{ref}}} & D_{\mathrm{sei}}^{T^{\mathrm{ref}}} & \rho_M & E_{k,\mathrm{sei}}^{T^{\mathrm{ref}}} & E_{D,\mathrm{sei}}^{T^{\mathrm{ref}}} & U_{\mathrm{sei}}(\mathrm{SOC}) \end{bmatrix}^{\mathrm{T}}$$

for $n_{SOC}$ SOC points. An estimate of this parameter vector is obtained by solving the following optimization problem [equations 32, 33]:

$$\underset{\theta_{\mathrm{cal}}}{\text{minimize}} \sum_{t_k=1}^{N_{\mathrm{cal}}} w_{\mathrm{cal}}(t_k) \left( Q_{\mathrm{cal}}(t_k) - Q_{\mathrm{cal}}^{\mathrm{mod}}(t_k) \right)^2$$

subject to (equation 5), (equation 6), (equation 10), (equation 10b), (equation 17)
using the data set consisting of the capacity evolution with respect to time denoted as $D_{cal} = \{I_{cal}(t_k), T_{cal}(t_k), Q_{cal}(t_k), t_k =$

1, ... , $N_{cal}\}$. Both the experimentally measured capacity $Q_{cal}(t_k)$ as well as the modelled capacity $Q_{\mathrm{cal}}^{\mathrm{mod}}(t_k)$ are both obtained by subjecting the battery to periodic characterization tests.

[Equation 10]:

$$I_{\mathrm{sei}}(t) = \cfrac{1}{\cfrac{1}{b_1(t)} + \cfrac{1}{b_2(t)} + \cfrac{1}{b_3(t)} \int_0^t I_{\mathrm{sei}}(t)dt}$$

$$b_1(t) = \beta k_{\mathrm{sei}}^{T^{\mathrm{ref}}} \exp\left( E_{k,\mathrm{sei}}^{T^{\mathrm{ref}}} \frac{1}{T(t)} \right) \exp\left( -\frac{1}{c_1} (U_-(\bar{c}_-(1,t)) \right.$$

$$\left. - U_{\mathrm{sei}} \right) \exp\left( -\frac{1}{\alpha c_1} \eta_-(\bar{c}_-(1,t), I(t)) \right)$$

$$b_2(t) = \beta D_{\mathrm{sei}}^{T^{\mathrm{ref}}} \exp\left( E_{D,\mathrm{sei}}^{T^{\mathrm{ref}}} \frac{1}{T(t)} \right) \exp\left( -\frac{1}{\alpha c_1} \eta_-(\bar{c}_-(1,t), I(t)) \right)$$

$$b_3(t) = \beta^2 \rho_M \exp\left( E_{D,\mathrm{sei}}^{T^{\mathrm{ref}}} \frac{1}{T(t)} \right) \exp\left( -\frac{1}{\alpha c_1} \eta_-(\bar{c}_-(1,t), I(t)) \right)$$

[Equation 10b]:

$$\left. \frac{\partial \bar{c}_i(\bar{r}, t)}{\partial \bar{r}} \right|_{\bar{r}=1} = -\frac{\tau_{i,d}}{3q_i} \left( I(t) + I_{\mathrm{sei}}(t) \right)$$

[Equation 17]:

$$\frac{dQ(t)}{dt} = \frac{1}{3600} I(t)$$

$$\bar{Q}(t) = \frac{Q(t)}{Q^{\mathrm{nom}}}$$

$$\bar{Q}_{\mathrm{loss}}(t) = 1 - \bar{Q}(t)$$

Cycle aging parameters

Besides calendar aging, the battery also ages due to its cycling. In this work, we found that surface cracking propagation is the degradation mechanism that allows to get the best fit from the different degradation mechanisms tested. The incorporation of a surface cracking propagation model to describe calendar and cycle aging dynamics has also been considered in. Assuming then that this is the main cause of cycle aging on top of the calendar aging described by an SEI layer growth model, the parameter vector to be estimated is equivalent to $\theta_{\text{lump,sc}}$, a grouped parameter vector associated with the cycle aging due to surface cracking propagation), which is denoted here as $\theta_{\text{cyc}}$ [equation 34]:

$$\theta_{\text{cyc}} = [m_{\text{rate}} \quad A_{\text{max}}]^{\text{T}}$$

The optimization problem to be solved in order to get an estimate of this parameter vector is given by [equations 35, 36]:

$$\underset{\theta_{\text{cyc}}}{\text{minimize}} \sum_{t_k=1}^{N_{\text{cyc}}} w_{\text{cyc}}(t_k) \left( Q_{\text{cyc}}(t_k) - Q_{\text{cyc}}^{\text{mod}}(t_k) \right)^2$$

subject to (5), (6), (10), (4), (4b), (17) where the data set used again consisted of the capacity evolution with respect to time denoted as $D_{cyc} = \{I_{cyc}(t_k), Q_{cyc}(t_k), t_k = 1, \dots, N_{cyc}\}$.

[Equation 4]:

$$\frac{\partial f_{bb}(t)}{\partial t} = m_{\text{rate}}(A_{\text{max}} - f_{bb}(t))|I(t)|$$

$$f_{bb}(0) = f_{bb,0}$$

$$I_{bb}(t) = f_{bb}(t)I_{\text{sei}}(t)$$

[Equation 4b]:

$$\left.\frac{\partial \bar{c}_i(\bar{r},t)}{\partial \bar{r}}\right|_{\bar{r}=1} = -\frac{\tau_{i,d}}{3q_i}(I(t) + I_{\text{sei}}(t) + I_{bb}(t))$$

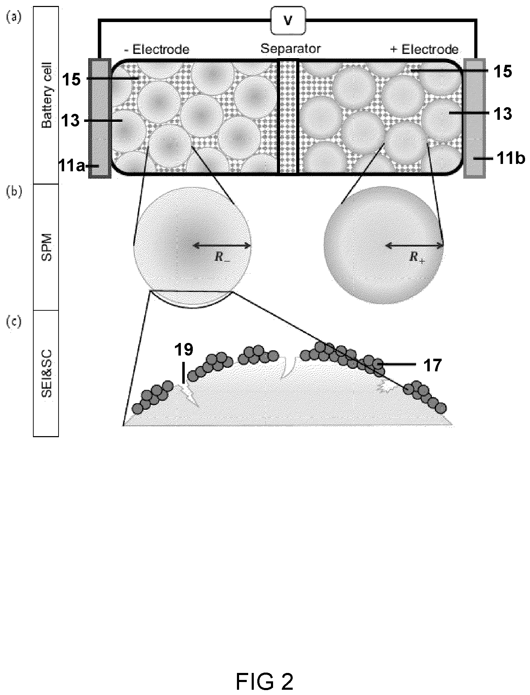

Fig. 2 shows a schematic diagram of an exemplary battery cell structure and degradation mechanisms. Components and aspects of an exemplary electrochemical model and associated degradation mechanisms used in an exemplary parameter identification method for lithium-ion batteries are illustrated. In (a) of fig. 2, a schematic diagram showing a longitudinal cross-sectional view of a lithium-ion battery cell is shown, comprising a negative electrode, a separator, and a positive electrode arranged between a negative current collector 11a and a positive current collector 11b. The negative electrode and positive electrode include solid-phase active material 13 particles, respectively, and an electrolyte 15 phase permeates the separator and the porous structures of the electrodes.

In (b) of fig. 2, the single-particle model (SPM) is illustrated that can be utilized in the electrochemical model to simulate battery cell electrochemistry and degradation mechanisms. In the SPM, each of the negative and positive electrodes can be represented by a single spherical particle, respectively. The model can account for solid-phase diffusion of lithium ions within the particles, and electrochemical reactions at the particle surfaces.

In (c) of fig. 2, the degradation mechanisms incorporated into the exemplary electrochemical model to represent battery aging is depicted. The solid-electrolyte interphase 17 (SEI) layer growth mechanism models calendar aging by simulating the formation and growth of the SEI layer on the surface of the negative electrode particle, due to side reactions between lithiated graphite and electrolyte components. This leads to loss of lithium inventory and capacity fade over time. The surface cracking 19 propagation mechanism models cycle aging by simulating mechanical degradation effects resulting from cyclic stress and strain experienced during operational use of the battery. Cracks form and propagate on the surface of electrode particles, increasing the surface area and promoting further SEI layer growth and degradation.

In this way, the electrochemical model integrates the SEI layer growth and surface cracking propagation mechanisms to accurately simulate battery behavior over its expected lifespan under various usage scenarios, as part of the parameter identification method described herein.

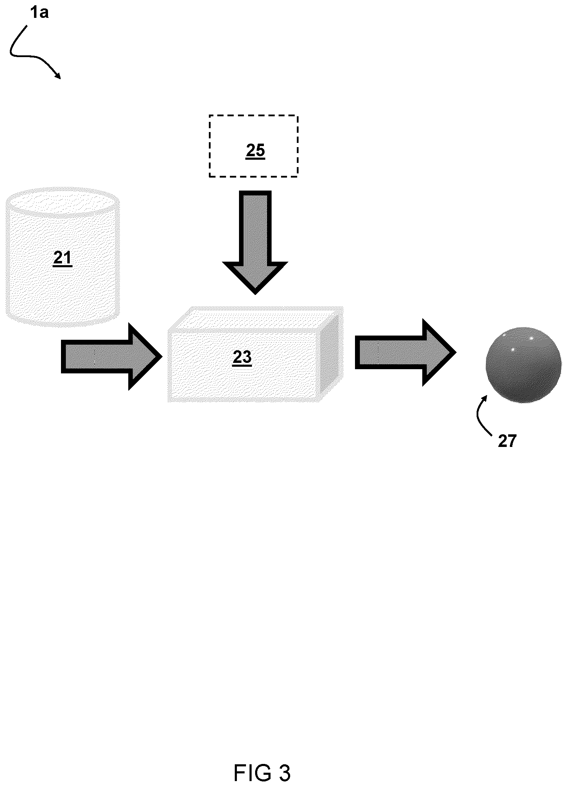

Fig. 3 shows a schematic diagram of an embodiment of an exemplary system 1a for parameter identification in an electrochemical model of batteries. A data storage component 21 stores measurement performance data obtained from battery testing under various operating conditions. This data is processed by an optimizer 23 which employs an optimization-based framework to solve separate optimization problems for different subsets of model parameters. An electrochemical model 25 is utilized that simulates battery cell electrochemistry and degradation mechanisms. This model 25 is adjusted with parameters estimated by the optimizer to reflect specific battery operating conditions and aging phenomena. The output from the system is an identified model 27 which is an updated version of the electrochemical model 25 that incorporates refined parameters to enhance battery characterization and management accuracy.

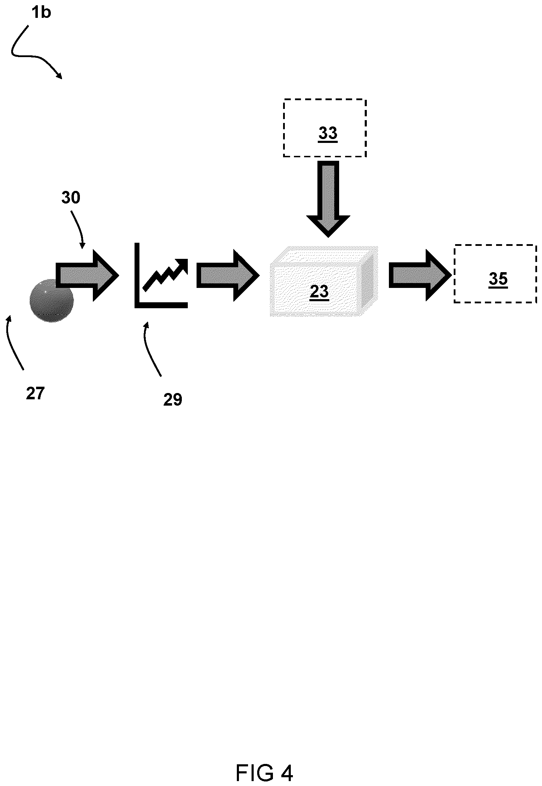

Fig. 4 shows a schematic diagram of an embodiment of an exemplary system 1b for achieving optimal usage of a battery even under varying costs, whilst minimizing degradation.

The identified model 27 is utilized to simulate 30 battery performance to generate prediction data 29. The prediction data 29 is then input into an optimizer 23, a computer-implemented program or algorithmic component, which also for instance receives input on current energy prices 33. The optimizer 31 may be configured to minimized costs while minimizing the degradation of the battery, a critical aspect of sustainable battery management. The optimizer processes these inputs to determine the optimal usage 35 of the battery.

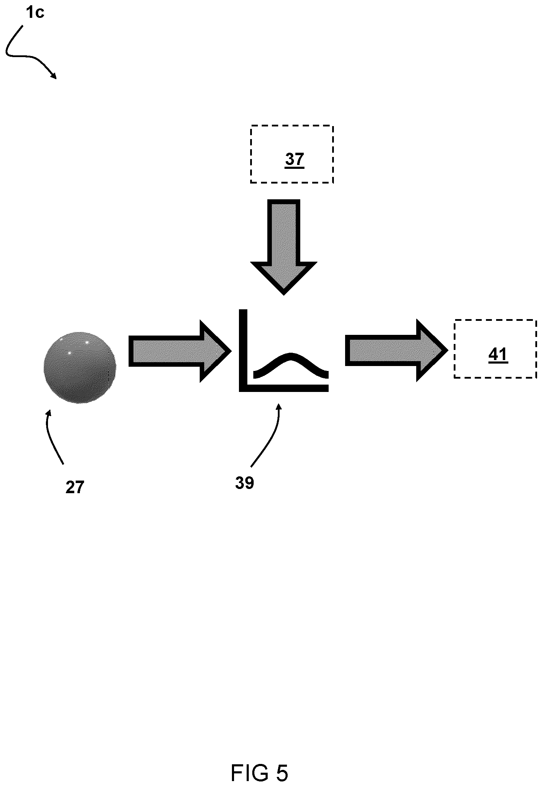

Fig. 5 shows a schematic diagram of an embodiment of a system 1c for determining a safe operating area for a battery system. The identification of an electrochemical model of a battery provides for an identified model 27.

Subsequent to this, degradation constraints 37, which encompass both calendar and cycle aging parameters such as solid-electrolyte interphase (SEI) layer growth and surface cracking propagation, are applied. These constraints can be applied to the identified model to modify the operational conditions.

Following the imposition of degradation constraints 37, the process involves a simulation 39 under these constraints, wherein the model is adapted to reflect degradation impacts. This refines the model to account for real-world aging effects under varied operating conditions.

A safe operating area 41 can be obtained indicating the establishment of operational boundaries within which the battery can function reliably and safely over its intended lifecycle. This area can be determined through iterative simulations that adjust for observed versus predicted degradation, ensuring the battery operates within parameters that prevent premature failure due to operational stresses.

Advantageously, battery integrity and operational efficiency can be better maintained through targeted modeling and constraint application, resulting in better management of battery operation and degradation.

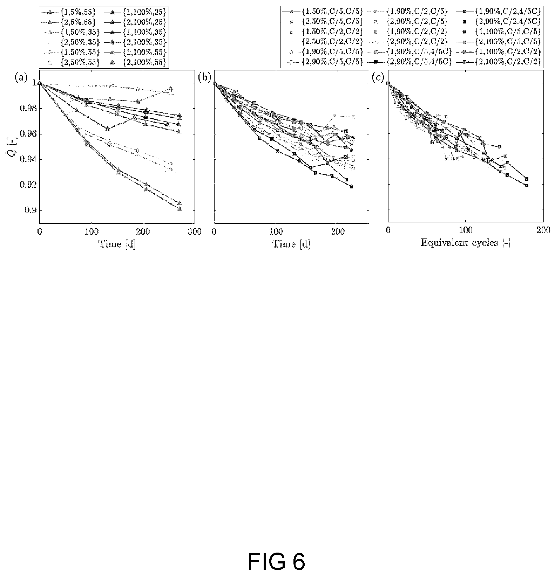

Fig. 6 shows a schematic diagram of exemplary graphs. In this figure, exemplary measurement performance data obtained under various battery operating conditions, used in the method for identifying parameters of an electrochemical model for batteries, is given.

In (a) of fig. 6, an evolution of normalized battery capacity over time for battery cells subjected to calendar aging tests at different temperatures and states of charge (SOC) is given. The data represents capacity loss due to calendar aging effects when batteries are stored at specific SOC levels and temperatures without cycling, thereby indicating degradation effects due to the passage of time.

In (b) of fig. 6, the evolution of normalized battery capacity over time for battery cells subjected to cycle aging tests under different cycling conditions, including varying charge/discharge rates and SOC windows, is given. This measurement performance data represents capacity loss due to cycle aging effects when batteries are subjected to repeated charge-discharge cycles under controlled conditions, indicating degradation effects due to operational use.

In (c) of fig. 6, the evolution of normalized battery capacity over equivalent cycles for the cycle aging tests is shown, correlating capacity loss with the number of charge-discharge cycles undergone by the battery cells.

The exemplary measurement performance data given in fig. 6 can be utilized in the optimization-based framework to estimate subsets of model parameters relevant under the specific operating conditions corresponding to the measurement performance data. By solving separate optimization problems for each subset, the electrochemical battery model is adjusted with the estimated parameters, thereby enabling accurate prediction of the battery's behavior over its expected lifespan under various usage scenarios.

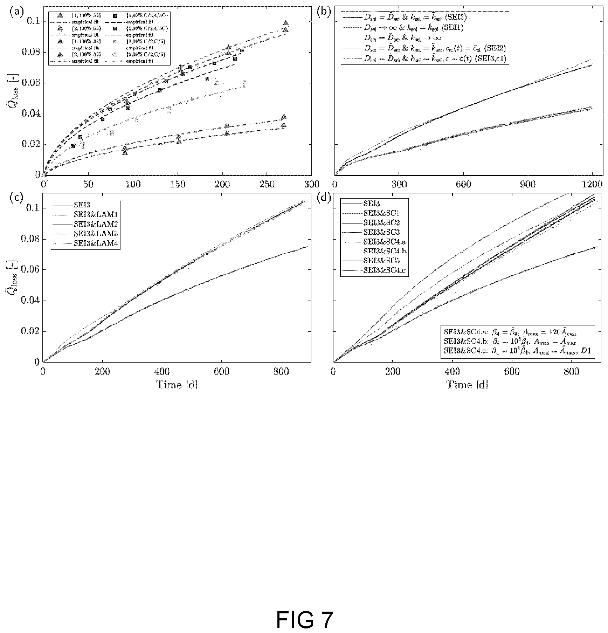

Fig. 7 shows a schematic diagram of exemplary graphs. Measurement performance data are compared with simulated capacity loss trajectories corresponding to various degradation mechanisms. In (a) of fig. 7, normalized capacity loss over time for selected battery cells under different aging conditions is shown, including calendar aging at 100% state of charge (SOC) at temperatures of 55°C and 35°C, and cycle aging at a ∆SOC (i.e. SOC window) of 90% with various charge and discharge rates. The experimental measurement performance data points (shown as markers) are plotted alongside empirical fits based on a square root of time dependency (shown as dashed curves), illustrating the observed degradation trends under specific operating conditions.

In (b) of fig. 7, capacity loss trajectories over time for different solid-electrolyte interphase (SEI) layer growth degradation models. The simulated capacity loss trajectories demonstrate various degradation pathways associated with SEI layer growth mechanisms and their ability to represent the measurement performance data. This figure exemplifies the estimation of calendar aging parameters relevant under specific operating conditions by solving optimization problems using the measurement data.

In (c) of fig. 7, capacity loss trajectories over time for different loss of active material (LAM) degradation models are shown. The simulated capacity loss trajectories are compared to the measurement performance data to evaluate the suitability of LAM mechanisms in modeling battery degradation. This comparison aids in including or excluding degradation mechanisms and parameters in order for the electrochemical battery model to best align with the observed aging phenomena.

In (d) of fig. 7, capacity loss trajectories over time for different surface cracking (SC) propagation degradation models, are shown. The simulated capacity loss trajectories are compared with the measurement performance data to assess the effectiveness of SC propagation mechanisms in explaining battery degradation during cycle aging. This comparison aids in adjusting the electrochemical battery model by incorporating mechanisms and parameters that best align with the observed aging phenomena.

Model parameters are divided into multiple subsets related to specific battery operating conditions and aging phenomena. An optimization-based framework is utilized to estimate each subset by solving separate optimization problems using measurement performance data. The adjusted electrochemical battery model, updated with the estimated parameters, is evaluated to ensure alignment with observed data, thereby enabling the selection and incorporation of appropriate degradation mechanisms into a comprehensive battery model. This model can predict the battery's behavior over its expected lifespan under various usage scenarios, facilitating characterization and operational management of batteries.

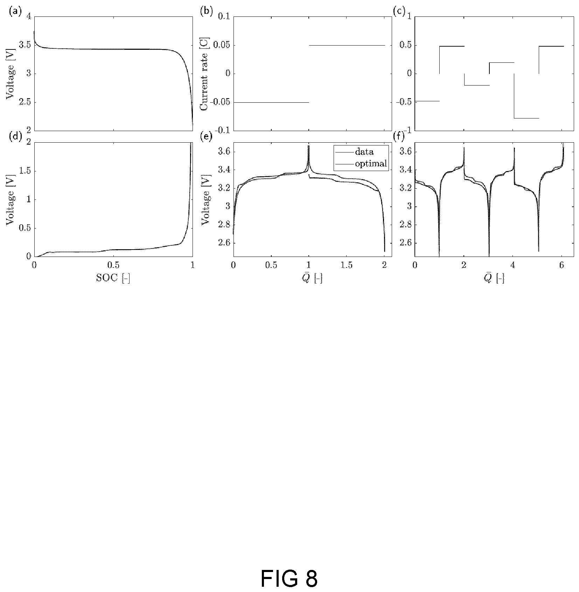

Fig. 8 shows a schematic diagram of exemplary graphs demonstrating both equilibrium and dynamic parameters. The method utilizes an optimization-based framework configured to estimate each subset of model parameters by solving separate optimization problems using measurement performance data relevant to specific operating conditions. Measurement performance data under various battery operating conditions is obtained. An electrochemical model is used to simulate battery cell electrochemistry. Moreover, model parameters are divided into subsets related to specific conditions. The model is then adjusted/adapted with the estimated parameters for enhanced characterization and operational management of batteries.

In (a) of fig. 8, an open-circuit potential (OCP) function of the positive electrode, namely for the exemplary lithium iron phosphate (LFP) electrode, which is utilized in determining equilibrium parameters that characterize the battery's behavior under stable conditions, is shown. This OCP function can be used modeling the thermodynamic properties of the electrode.

In (b) of fig. 8, a low-current charge/discharge current profile, specifically a constant current operation at a rate like C/20, used to obtain measurement performance data under near-equilibrium conditions, is shown. Such data can be used for estimating the equilibrium parameters by minimizing the difference between measured and modeled voltage under low-current conditions.

In (c) of fig. 8, a dynamic charge/discharge current profile involving various current rates, employed to obtain measurement performance data under operational conditions, is shown. This data is used to estimate dynamic parameters that indicate the battery's response during typical usage, including parameters like solid-phase diffusion time coefficients and reaction rate constants.

In (d) of fig. 8, an open-circuit potential (OCP) function of the negative electrode, such as the graphite electrode, also used in determining equilibrium parameters, is shown. Similar to the positive electrode, this OCP function helps in modeling the electrode's thermodynamic behavior.

In (e) of fig. 8, a voltage response of the battery during the low-current charge/discharge test depicted in (b) of fig. 8, is shown. It includes both the measured voltage data and the model's output after equilibrium parameter estimation. The close alignment between the measured and modeled voltages demonstrates the accuracy of the estimated equilibrium parameters.

In (f) of fig. 8, a voltage response during the dynamic charge/discharge test illustrated in (c) of fig. 8, including both the measured data and the model's output after dynamic parameter estimation, is shown. This comparison validates the dynamic parameters estimated by solving optimization problems that minimize the difference between measured and modeled voltage during varying current rates.

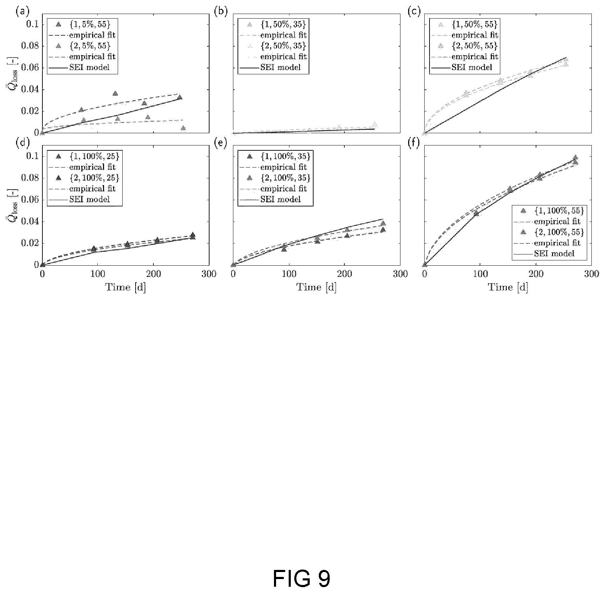

Fig. 9 shows a schematic diagram of exemplary graphs illustrating the evolution of normalized capacity loss with respect to time for calendar aging data obtained at different operating conditions. Empirical fits are shown as dashed curves, whereas capacity loss predictions of identified model are shown as solid blue curves.

The measurement performance data (e.g., measured capacity loss data points) may be obtained from batteries held at specific states of charge (SOC) and temperatures without cycling. The notation of the legend in fig. 9 is {Cell number, SOC [%], temperature [degrees Celsius]}

The electrochemical battery model is adjusted by estimating calendar aging parameters associated with solid electrolyte interphase (SEI) layer growth, by solving optimization problems to fit the model to the measured capacity loss data.

The adjusted electrochemical battery model predictions (solid curves) are compared with the measurement performance data (data points), demonstrating alignment between the model and observed data.

The measurement performance data can be utilized to estimate calendar aging parameters associated with SEI layer growth, by modeling capacity fade over time under storage conditions and solving optimization problems to fit the model to the measured capacity loss data.

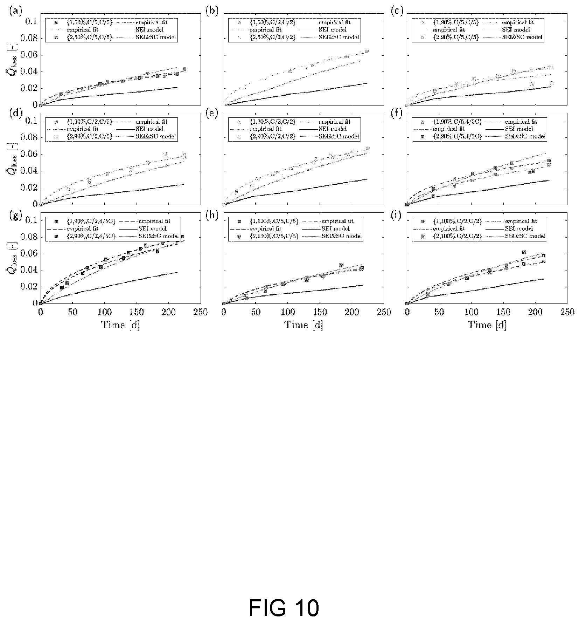

Fig. 10 shows a schematic diagram of exemplary graphs. An evolution of normalized capacity loss with respect to time for cycle aging data obtained at different operating conditions is shown. Empirical fits are shown as dashed curves, whereas capacity loss predictions of the identified model are shown as solid blue curves for the SEI layer alone and solid green curves for the SEI layer together with surface cracking (SC) propagation. The notation of the legend is {Cell number, $\Delta$SOC[%], charge rate [C-rate], discharge rate [C-rate]}.

Each graph corresponds to a specific set of battery operating conditions. Data points (represented by markers) indicate the experimentally measured normalized capacity loss over time, obtained from measurement performance data of batteries subjected to repeated charge-discharge cycles under controlled conditions.

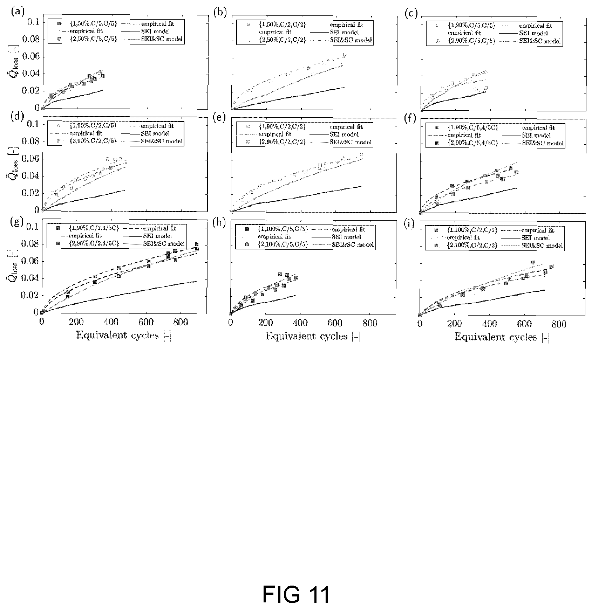

Fig. 11 shows a schematic diagram of exemplary graphs. An evolution of normalized capacity loss with respect to equivalent cycles for cycle aging data obtained at different operating conditions is shown. Empirical fits are shown as dashed curves, whereas capacity loss predictions of the identified model are shown as solid blue curves for the SEI layer alone and solid green curves for the SEI layer together with surface cracking (SC) propagation. The notation of the legend is {Cell number, $\Delta$SOC[%], charge rate [C-rate], discharge rate [C-rate]}.

The graphs have a horizontal axis representing equivalent cycles and a vertical axis representing normalized capacity loss (capacity fade). Data points depict experimentally measured capacity loss during cycle aging tests under various battery operating conditions, including different state of charge (SOC) windows and charge/discharge current rates. Specifically, the cycle aging conditions include SOC windows of 50%, 90%, and 100%, and charge/discharge rates such as C/5, C/2, and 4/5C.

A first model prediction curve (cf. SEI model) represents capacity loss predictions generated using an electrochemical battery model adjusted with parameters estimated for calendar aging, specifically incorporating a solid-electrolyte interphase (SEI) layer growth model. A second model prediction curve (cf. SEI&SC model) represents capacity loss predictions generated using the electrochemical battery model adjusted with parameters estimated for both calendar aging and cycle aging, incorporating both SEI layer growth and surface cracking propagation models.

The second model prediction curve closely aligns with the experimental data points across various cycling conditions, demonstrating the effectiveness of the parameter identification method in accurately modeling battery degradation mechanisms over equivalent cycles. The data indicates that incorporating both SEI layer growth and surface cracking propagation mechanisms into the electrochemical model provides a more accurate prediction of capacity loss during cycle aging compared to using the SEI layer growth model alone.

Measurement performance data of the battery under various operating conditions is obtained, employing an electrochemical model that includes aging mechanisms such as SEI layer growth and surface cracking propagation, and dividing model parameters into multiple subsets related to specific battery operating conditions and aging phenomena. An optimization-based framework is utilized to estimate each subset of model parameters by solving separate optimization problems using the measurement performance data corresponding to specific operating conditions.

The adjusted electrochemical battery model with the estimated parameters can then be used for various applications such as for instance characterization and operational management of batteries, including e.g. predicting battery capacity fade under different usage scenarios and enabling operation within a defined safe operating area. This approach allows e.g. for accurate prediction of battery performance over its expected lifespan and enhances the ability to manage battery health and safety effectively.

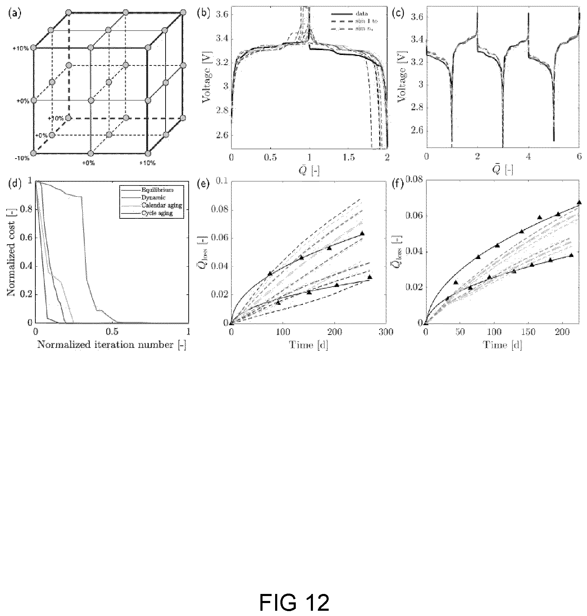

Fig. 12 shows a schematic diagram of exemplary graphs. Fig. 12 illustrated exemplary results of perturbing the different fitting parameters by 10% as in (a) when considering the parameters of (b) equilibrium, (c) dynamic, (e) calendar aging, and (f) cycle aging. The figure also shows in (d) the evolution of the normalized cost function with respect to a normalized iteration number for each of the considered optimization problems solved using a trust-region-reflective (TRR) algorithm. However, other algorithms can also be used.

In (a) of fig. 12, an exploration of the parameter space for equilibrium parameters is illustrated. All possible combinations and directions in the parameter space are considered by perturbing each parameter component by a predetermined percentage (e.g., 10%), enabling a comprehensive assessment of the parameter influence on the model's performance.

In (b) of fig. 12, a voltage response resulting from perturbations in the equilibrium parameters is shown. The figure demonstrates how variations in these parameters affect the modeled voltage output, highlighting the sensitivity of the electrochemical battery model to changes in equilibrium parameters. The optimal parameter set yields a voltage curve that closely aligns with measured data, whereas other perturbed parameter sets result in significant deviations.

In (c) of fig. 12, a voltage response due to perturbations in the dynamic parameters is shown. This figure indicates that variations in dynamic parameters lead to relatively minor differences in the voltage output, suggesting that multiple parameter combinations may produce similar model outputs.

In (d) of fig. 12, convergence results for each optimization problem solved using the trust-region-reflective (TRR) method is shown. The figure shows the decrease in the cost function over iterations for different sets of parameters, including equilibrium, dynamic, calendar aging, and cycle aging parameters. The convergence rates indicate the efficiency of the optimization algorithm in reaching optimal parameter values, with the cycle aging parameters converging most rapidly due to their lower dimensionality.

In (e) of fig. 12, the capacity loss response obtained by perturbing the calendar aging parameters under two different conditions, is shown. The figure demonstrates how variations in the calendar aging parameters impact the model's prediction of capacity loss over time, emphasizing the model's sensitivity to these parameters and the necessity of accurate estimation for reliable long-term predictions.

In (f) of fig. 12, the effect of variations in cycle aging parameters on the model's capacity loss prediction during cycling operations is illustrated, showing that the optimal parameter set achieves a balanced fit across different operating conditions.

Dividing model parameters into subsets related to specific battery operating conditions and aging phenomena and applying optimization algorithms to estimate each subset of parameters using relevant measurement performance data, provides for an updated electrochemical battery model that better predicts the battery's behavior over its expected lifespan under various usage scenarios, thereby facilitating improved characterization and operational management of batteries.

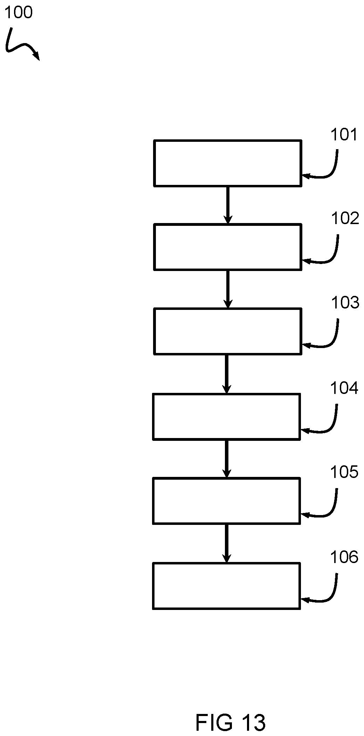

Fig. 13 shows a schematic diagram 100 of a method for identifying parameters of an electrochemical model for characterization and/or operational management of batteries. In a first step 101, measurement performance data of a battery under various battery operating conditions is obtained. In a second step 102, an electrochemical model is employed to simulate battery cell electrochemistry and degradation mechanisms. In a third step 103, model parameters of the electrochemical battery model are divided into multiple subsets related to specific battery operating conditions and aging phenomena. In a first step 104, an optimization-based framework is utilized that is configured to estimate each subset of model parameters by solving separate optimization problems using measurement performance data, wherein each optimization problem estimates a subset of parameters relevant under the specific operating conditions corresponding to the measurement performance data. In a fifth step 105, the electrochemical battery model is adjusted with the estimated parameters. In a sixth step 106, the updated electrochemical battery model is used for characterization and/or operational management of batteries.

Initially, the model may identify the parameters that describe the battery in its brand new, unused state. These parameters typically include aspects like the battery's initial capacity, internal resistance, and electrochemical properties that dictate how it performs during charging and discharging. Identifying these parameters accurately is important for setting a baseline against which aging and degradation can be measured.

As the battery ages through repeated use (cycle aging) and merely passing of time (calendar aging), its performance characteristics change. For example, the capacity might decrease, internal resistance might increase, and other electrochemical changes might occur due to the formation of an SEI layer or mechanical stresses leading to surface cracking.

The model can effectively update the initial parameters to reflect changes due to at least calendar aging and cycle aging. Calendar aging relates to changes that occur as time passes, regardless of battery usage. For instance, chemical compositions can slowly degrade even when the battery is not in use. Cycle aging relates to changes that happen as a result of charging and discharging the battery. These are typically due to physical and chemical stresses on the battery's materials during the entry and exit of lithium ions for lithium ion batteries.

By combining these aspects, initial parameter identification and their evolution due to aging, the model can effectively provide a comprehensive view of the battery's performance throughout its entire life. This lifecycle model is invaluable for predicting when a battery will need maintenance or replacement and for understanding how batteries will perform under different usage patterns and environmental conditions.

A multi-step identification procedure may be used to provide an improved structured approach to estimate and update the parameters of the battery model throughout its lifecycle. The initial step may involve determining the basic electrochemical characteristics of the battery materials in a controlled setting. OCP can be important for establishing the baseline electrochemical properties of the electrodes when no current flows.

Equilibrium parameters can be identified using low-current tests to determine the battery's behavior under minimal stress, which closely approximates its theoretical or equilibrium state.

Dynamic parameters can be determined, involving identifying how the battery behaves under normal operational conditions, including varying currents and operational stresses.

Parameter identification for aged cells can be performed. Calendar aging parameters can be identified for the battery's aging under conditions where the battery is stored at different states of charge (SOC) and temperatures but not cycled. Cycle aging parameters may involve parameters related to how the battery ages with usage, under different cycling conditions (charge/discharge rates and depth of discharge).

The multi-step procedure effectively supports the comprehensive parameter identification by covering the full spectrum of battery life, from fresh to end-of-life, under various operational and resting conditions.

The model parameters that define the fresh battery state can be fine-tuned using empirical data derived from initial testing phases. These parameters include those that control the rate of lithium ion movement through the electrolyte and electrode materials, and how they interact at the electrode interfaces.

In the calendar and cycle aging identification stages, the model parameters may be further adapted to account for the degradation mechanisms that have been identified as predominant during aging studies. These include the growth of the SEI layer, which affects ion mobility and therefore battery capacity and resistance, and mechanical degradation like surface cracking, which can change the electrode material properties.

Each of these steps may involve adjusting the model to reflect real-world operational and aging effects on the battery.

It will be appreciated that the method may include computer implemented steps. All above mentioned steps can be computer implemented steps. Embodiments may comprise computer apparatus, wherein processes performed in computer apparatus. The invention also extends to computer programs, particularly computer programs on or in a carrier, adapted for putting the invention into practice. The program may be in the form of source or object code or in any other form suitable for use in the implementation of the processes according to the invention. The carrier may be any entity or device capable of carrying the program. For example, the carrier may comprise a storage medium, such as a ROM, for example a semiconductor ROM or hard disk. Further, the carrier may be a transmissible carrier such as an electrical or optical signal which may be conveyed via electrical or optical cable or by radio or other means, e.g. via the internet or cloud.

Some embodiments may be implemented, for example, using a machine or tangible computer-readable medium or article which may store an instruction or a set of instructions that, if executed by a machine, may cause the machine to perform a method and/or operations in accordance with the embodiments.

Various embodiments may be implemented using hardware elements, software elements, or a combination of both. Examples of hardware elements may include processors, microprocessors, circuits, application specific integrated circuits (ASIC), programmable logic devices (PLD), digital signal processors (DSP), field programmable gate array (FPGA), logic gates, registers, semiconductor device, microchips, chip sets, et cetera. Examples of software may include software components, programs, applications, computer programs, application programs, system programs, machine programs, operating system software, mobile apps, middleware, firmware, software modules, routines, subroutines, functions, computer implemented methods, procedures, software interfaces, application program interfaces (API), methods, instruction sets, computing code, computer code, et cetera.

Herein, the invention is described with reference to specific examples of embodiments of the invention. It will, however, be evident that various modifications, variations, alternatives and changes may be made therein, without departing from the essence of the invention. For the purpose of clarity and concise description features are described herein as part of the same or separate embodiments, however, alternative embodiments having combinations of all or some of the features described in these separate embodiments are also envisaged and understood to fall within the framework of the invention as outlined by the claims. The specifications, figures and examples are, accordingly, to be regarded in an illustrative sense rather than in a restrictive sense. The invention is intended to embrace all alternatives, modifications and variations which fall within the scope of the appended claims. Further, many of the elements that are described are functional entities that may be implemented as discrete or distributed components or in conjunction with other components, in any suitable combination and location.

In the claims, any reference signs placed between parentheses shall not be construed as limiting the claim. The word 'comprising' does not exclude the presence of other features or steps than those listed in a claim. Furthermore, the words 'a' and 'an' shall not be construed as limited to 'only one', but instead are used to mean 'at least one', and do not exclude a plurality. The term "and/or" includes any and all combinations of one or more of the associated listed items. The mere fact that certain measures are recited in mutually different claims does not indicate that a combination of these measures cannot be used to an advantage.

## Claims

1. A method for identifying parameters of an electrochemical model for characterization and/or operational management of batteries, the method comprising:

   obtaining measurement performance data of a battery under various battery operating conditions;
   employing an electrochemical model to simulate battery cell electrochemistry and degradation mechanisms;
   dividing model parameters of the electrochemical battery model into multiple subsets related to specific battery operating conditions and aging phenomena;

   utilizing an optimization-based framework that is configured to estimate each subset of model parameters by solving separate optimization problems using measurement performance data, wherein each optimization problem estimates a subset of parameters relevant under the specific operating conditions corresponding to the measurement performance data;
   adjusting the electrochemical battery model with the estimated parameters; and
   using the updated electrochemical battery model for characterization and/or operational management of batteries.

2. The method according to claim 1, wherein the model parameters are divided into subsets corresponding to different stages and conditions of battery use and aging, and each subset is estimated using measurement data relevant to that mechanism.

3. The method according to claim 1 or 2, wherein a multi-step identification procedure is performed including:

identifying a set of initial parameters of a new battery cell, the initial parameters including equilibrium parameters that characterize the battery's behavior under pseudo-equilibrium-conditions and dynamic parameters that characterize the battery's behavior under dynamic operational conditions;
utilizing the identified initial parameters as a basis for modeling battery aging, wherein the modeling includes:

incorporating calendar aging parameters into the model, which account for degradation effects due to the passage of time; and
incorporating cycle aging parameters into the model, which account for degradation effects due to operational use;

wherein the initial parameters serve as foundational configurations for the battery model, and adjustments are made to these configurations based on the calendar aging parameters and cycle aging parameters to model and/or predict the battery's degradation over time.

4. The method according to any one of the preceding claims, wherein the parameter identification comprises:

determining, using low-current and/or open-circuit potential measurement performance data, a low-current or open-circuit potential, OCP, function of the battery electrodes to establish baseline equilibrium parameters;
estimating, using dynamic measurement performance data including charging and discharging at various rates, dynamic parameters that indicate the battery's response under operational conditions;
estimating, using data from aging tests where batteries are held at specific states of charge without cycling, calendar aging parameters that indicate calendar aging;
estimating, using data from measurements in which the battery is subjected to repeated charge-discharge cycles under controlled conditions, cycle aging parameters that indicate cycle aging;
applying an optimization algorithm to refine all identified parameters ensuring the model predictions align closely with the observed data; and
combining all identified parameters into a comprehensive battery model for predicting the battery's behavior over its expected lifespan under various usage scenarios.

5. The method according to claim 4, wherein OCP functions per electrode are determined by measuring voltage response of the battery electrodes under low-current or zero-current conditions and fitting the data to obtain functional representations of the OCPs, wherein the OCP functions are determined by fitting measured OCP data to a set of basis functions selected from exponentials and hyperbolic functions.

6. The method according to claim 3, 4 or 5, wherein estimating equilibrium parameters involves solving a nonlinear least squares optimization problem that minimize the difference between measured and modeled voltage under low-current conditions.

7. The method according to any one of the preceding claims 3-6, wherein estimating dynamic parameters involves solving an optimization problem that minimize the difference between measured and modeled voltage during charge/discharge cycles at different current rates, to determine solid-phase diffusion time coefficients, reaction rate constants for positive and negative electrodes, and/or a lumped resistance parameter.

8. The method according to any one of the preceding claims 4-7, wherein estimating calendar aging parameters involves modeling capacity fade over time under storage conditions and solving optimization problems to fit the model to the measured capacity loss data, in order to determine at least parameters associated with solid electrolyte interphase (SEI) layer growth.

9. The method according to claim 8, wherein the calendar aging parameters further include parameters that are function of the state of charge (SOC) so as to account for SOC-dependent degradation.

10. The method according to any one of the preceding claims 4-9, wherein estimating cycle aging parameters involves modeling capacity fade due to cycling-induced degradation mechanisms and solving optimization problems to fit the model to the measured capacity loss data during cycling, to determine parameters associated with at least surface cracking propagation in the electrode materials of the battery.

11. The method according to any preceding claims, wherein the battery model is a physics-based electrochemical model, comprising:

a single-particle model (SPM) for simulating the electrochemical interactions within the battery under various operational states;

an extension of the single-particle model to include degradation mechanisms represented by solid-electrolyte interphase (SEI) layer growth for calendar aging and surface cracking propagation for cycle aging, whereby:

the SEI layer growth is modeled to reflect degradation due to chemical and physical changes occurring over time as a result of environmental conditions and state of charge;

the surface cracking propagation is modeled to account for mechanical degradation effects resulting from the cyclic stress and strain experienced during operational use of the battery; and

wherein the integrated SEI layer growth and surface cracking propagation mechanisms are adjusted based on the initial equilibrium and dynamic parameters.

12. The method according to any one of the preceding claims, wherein discretization of the model equations is performed using spectral methods.

13. A system for identifying parameters of an electrochemical model that includes aging mechanisms for characterization and/or operational management of batteries, the system comprising:

one or more processors;

memory storing instructions that, when executed by the one or more processors, perform the method according to claim 1-12.

14. A method for operating a lithium-ion battery within a defined safe operating area, determined based on the electrochemical model parameters identified according to the method according to any one of the preceding claims 1-12.

15. A system for parameter identification in an electrochemical model of batteries, the system comprising:

a battery testing apparatus configured to simulate operational conditions and collect measurement performance data under various battery operating conditions;

at least one processing unit that is configured to perform the method according to any one of the preceding claims 1-12, using the measurement performance data collected by the battery testing apparatus, to identify parameters of an electrochemical model that includes aging mechanisms for characterization and/or operational management of batteries.

1

| 3 |
| :-: |

| 5 |
| :-: |

| 7 |
| :-: |

| 9 |
| :-: |

FIG 1

FIG 2

1a

25

21

23

27

FIG 3

1b

30

27    29

33

23    35

FIG 4

1c

37

41

27

39

FIG 5

FIG 6

FIG 7

FIG 8

FIG 9

FIG 10

FIG 11

FIG 12

100

101

102

103

104

105

106

FIG 13

Europäisches
Patentamt

European
Patent Office

Office européen
des brevets

# EUROPEAN SEARCH REPORT

**Application Number**

EP 24 21 1265

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | SAHAY RAHUL ET AL: "Parameter Identification and Optimization for Lithium-Ion Battery State of Health Detection", 2024 IEEE INTERNATIONAL CONFERENCE ON PROGNOSTICS AND HEALTH MANAGEMENT (ICPHM), IEEE, 17 June 2024 (2024-06-17), pages 356-366, XP034668506, DOI: 10.1109/ICPHM61352.2024.10626309 [retrieved on 2024-08-13] * figures 1, 3; table 1 * ----- | 1-15 | INV. G01R31/367 G01R31/374 G01R31/392 |
| A | HE WEI ET AL: "An extended single-particle model of lithium-ion batteries based on simplified solid-liquid diffusion process", ISCIENCE, CELL PRESS, US, vol. 27, no. 11, 27 August 2024 (2024-08-27), XP087677659, ISSN: 2589-0042, DOI: 10.1016/J.ISCI.2024.110764 [retrieved on 2024-08-27] * figures 1, 7; tables 1, 4, 5 * ----- | 1-15 | |
| | | | TECHNICAL FIELDS SEARCHED (IPC) |
| | | | G01R |
| A | SONG MINSEOK ET AL: "Parameter sensitivity analysis of a reduced-order electrochemical-thermal model for heat generation rate of lithium-ion batteries", APPLIED ENERGY, ELSEVIER SCIENCE PUBLISHERS, GB, vol. 305, 5 October 2021 (2021-10-05), XP086855158, ISSN: 0306-2619, DOI: 10.1016/J.APENERGY.2021.117920 [retrieved on 2021-10-05] * figure 4; table 1 * ----- -/-- | 1-15 | |

The present search report has been drawn up for all claims

| Place of search | Date of completion of the search | Examiner |
|---|---|---|
| Munich | 28 March 2025 | Agerbaek, Thomas |

EPO FORM 1503 03.82 (P04C01)

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

    .............................................................................................

& : member of the same patent family, corresponding
document

Europäisches
Patentamt

European
Patent Office

Office européen
des brevets

# EUROPEAN SEARCH REPORT

**Application Number**

EP 24 21 1265

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | NING JIN ET AL: "Parameter estimation of an electrochemistry-based lithium-ion battery model using a two-step procedure and a parameter sensitivity analysis", INTERNATIONAL JOURNAL OF ENERGY RESEARCH, WILEY, CHICHESTER, GB, vol. 42, no. 7, 12 March 2018 (2018-03-12), pages 2417-2430, XP071644526, ISSN: 0363-907X, DOI: 10.1002/ER.4022 * abstract; figure 1; table 1 * | 1-15 | |
| A | LI JUNFU ET AL: "A novel method for capacity fade analysis of lithium-ion batteries based on multi-physics model", 2016 IEEE INTERNATIONAL CONFERENCE ON PROGNOSTICS AND HEALTH MANAGEMENT (ICPHM), IEEE, 20 June 2016 (2016-06-20), pages 1-7, XP032945054, DOI: 10.1109/ICPHM.2016.7542834 [retrieved on 2016-08-12] * figures 1, 6; table 1 * | 1-15 | |

TECHNICAL FIELDS
SEARCHED (IPC)

The present search report has been drawn up for all claims

| Place of search | Date of completion of the search | Examiner |
|---|---|---|
| Munich | 28 March 2025 | Agerbaek, Thomas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................................

& : member of the same patent family, corresponding document

EPO FORM 1503 03.82 (P04C01)

page 2 of 2